# EUROPEAN PATENT APPLICATION

(11) **EP 4 608 109 A1**
(43) Date of publication of application: **27.08.2025**
(21) Application number: 25157541.1
(22) Date of filing: 12.02.2025
(51) Int. Cl.: H10K 59/122, H10K 59/131

(54) **DISPLAY DEVICE AND METHOD OF FABRICATING THE DISPLAY DEVICE**

(30) Priority: 22.02.2024 KR 20240025862
(71) Applicant: Samsung Display Co., Ltd., Yongin-si, Gyeonggi-do 17113 (KR)
(72) Inventor: LEE, Sang Jin, Yongin-si (KR); LEE, Chang Suk, Yongin-si (KR); CHANG, Chong Sup, Yongin-si (KR); CHA, Myoung Geun, Yongin-si (KR)
(74) Representative: Marks & Clerk LLP

(57) **Abstract**

A display device includes a substrate including a main area and a sub-area disposed on one side of the main area; an anode electrode located on the main area of the substrate; a pixel defining layer located on the anode electrode, covering the edge of the anode electrode and defining a first opening; a bank structure located on the pixel defining layer and defining a second opening, the bank structure including a first bank layer and a second bank layer having a tip protruding further toward the first opening than a side surface of the first bank layer; and a pad structure located on the sub-area of the substrate and not overlapping the main area. The pad structure includes a pad electrode; a pad anode electrode located on the pad electrode; and a pad bank structure located on the pad anode electrode.

## Description

### BACKGROUND

### 1. Field

The present disclosure relates to a display device and a method of fabricating the display device.

### 2. Description of the Related Art

As the information society develops, the demand for display devices of various forms for displaying images is increasing. For example, display devices are applied to various electronic devices such as, for example, smartphones, digital cameras, notebook computers, navigation devices, and smart televisions. The display devices may be flat panel display devices such as, for example, liquid crystal display devices, field emission display devices, and organic light emitting display devices. Among these flat panel display devices, a light emitting display device includes a light emitting element that enables each pixel of a display panel to emit light by itself. Thus, the light emitting display device can display an image without a backlight unit that provides light to the display panel.

With the recent development of various electronic devices, the demand for high-resolution display devices is increasing. Since high-resolution display devices may be required to have a high pixel density, a gap between light emitting elements respectively overlapping emission areas may be reduced. Therefore, a high-resolution display device may be formed by a pattern process for forming individual pixels rather than a process using a fine metal mask.

### SUMMARY

Aspects of the present disclosure provide a display device forming separated light emitting elements in each emission area without a separate fine metal mask and including a pad structure configured of the same material and layer as a structure disposed in a display area.

Aspects of the present disclosure are to solve defects that occur during a manufacturing process of a pad structure.

However, aspects of the present disclosure are not restricted to the one set forth herein. The above and other aspects of the present disclosure will become more apparent to one of ordinary skill in the art to which the present disclosure pertains by referencing the detailed description of the present disclosure given below.

In an embodiment of the disclosure, a display device includes a substrate including a main area and a sub-area disposed on one side of the main area; an anode electrode located on the main area of the substrate; a pixel defining layer located on the anode electrode, covering an edge of the anode electrode and defining a first opening; a bank structure located on the pixel defining layer and defining a second opening, the bank structure including a first bank layer and a second bank layer having a tip protruding further toward the first opening than a side surface of the first bank layer; and a pad structure located on the sub-area of the substrate and not overlapping the main area, wherein the pad structure includes a pad electrode; a pad anode electrode located on the pad electrode and including a same material as the anode electrode; and a pad bank structure located on the pad anode electrode and including a same material as the bank structure.

In an embodiment, the display device may further include a pad inorganic layer located on the pad anode electrode and defining a third opening, wherein the pad inorganic layer includes a same material as the pixel defining layer.

In an embodiment, the pad inorganic layer may surround the third opening and entirely covers the edge of the pad anode electrode.

In an embodiment, the pad anode electrode entirely may cover the pad electrode and is entirely in contact with the pad electrode.

In an embodiment, the pad anode electrode may be in contact with the pad bank structure at a portion overlapping the third opening, and the pad bank structure and the pad electrode are electrically connected by the pad anode electrode.

In an embodiment, a first width of the pad electrode in a direction parallel to the substrate may be smaller than a second width of the pad anode electrode in the direction parallel to the substrate.

In an embodiment, the display device may further include a residual pattern located between the anode electrode and the pixel defining layer in a direction perpendicular to the substrate, wherein the residual pattern includes a transparent oxide electrode (TCO).

In an embodiment, the display device may further include a light emitting layer located on the anode electrode and in contact with the side surface of the first bank layer; and a cathode electrode located on the light emitting layer and in contact with the side surface of the first bank layer, wherein the light emitting layer may be in contact with the residual pattern, and the cathode electrode is electrically connected to the first bank layer.

In an embodiment, the display device may further include a pad residual pattern located between the pad anode electrode and the pad inorganic layer in a direction perpendicular to the substrate, wherein the pad residual pattern may include a same material as the residual pattern.

In an embodiment, the pad residual pattern may be completely surrounded by the pad anode electrode and the pad inorganic layer.

In an embodiment, the pad residual pattern may completely cover the pad anode electrode and the pad residual pattern may be in contact with the pad bank structure at a portion overlapping the third opening.

In an embodiment, the pad anode electrode may completely cover the pad electrode in a plan view, the pad inorganic layer may expose the pad anode electrode at a portion overlapping the third opening in the plan view, and the pad inorganic layer may entirely cover the edge of the pad anode electrode in the plan view.

In an embodiment, the pad bank structure may include a first pad bank layer including a same material as the first bank layer and a second pad bank layer including a same material as the second bank layer.

In an embodiment, the first bank layer and the first pad bank layer may include aluminium (Al), and the second bank layer and the second pad bank layer include titanium (Ti).

In an embodiment, the display device may further include a dam structure between the bank structure and the pad bank structure, wherein the bank structure and the pad bank structure may be spaced apart from each other.

In an embodiment, the first opening may be completely surrounded by the second opening in a plan view.

In an embodiment, the display device may further include a pad organic layer located on the pad electrode, defining a third opening, and including an organic insulating material, wherein the pad organic layer covers an edge of the pad electrode, and the pad organic layer is in contact with a side surface of the pad anode electrode.

In an embodiment of the disclosure, a method of fabricating a display device includes forming a pad electrode on a substrate, forming a pad anode electrode on the pad electrode, and forming a sacrificial layer on the pad anode electrode; after forming a pad inorganic layer on the sacrificial layer, removing a portion of the pad inorganic layer and a portion of the sacrificial layer through an etching process, wherein removing the portion of the pad inorganic layer and the portion of the sacrificial layer exposes the pad anode electrode; and after forming a pad bank structure on the pad anode electrode and the pad inorganic layer, removing a portion of the pad bank structure.

In an embodiment, based on removing the portion of the pad inorganic layer, a remaining portion of the pad inorganic layer may entirely cover an edge of the pad anode electrode.

In an embodiment, the pad anode electrode may be in contact with the pad electrode and the pad bank structure, and the pad electrode and the pad bank structure may be electrically connected by the pad anode electrode.

At least some of the above and other features of the invention are set out in the claims.

A display device of an embodiment may include a pad structure including the same material as a bank structure disposed in a display area to be formed during the same process. The pad structure may include a pad anode electrode entirely covering a pad electrode, a pad inorganic layer covering the edge of the pad anode electrode, and a pad residual pattern, thereby solving pad electrode defects caused during the manufacturing process of a pad structure.

However, the effects of the present disclosure are not restricted to the ones set forth herein. The above and other effects of the present disclosure will become more apparent to one of ordinary skill in the art to which the present disclosure pertains by referencing the claims.

### BRIEF DESCRIPTION OF THE DRAWINGS

The above and other aspects and features of the present disclosure will become more apparent by describing in detail embodiments thereof with reference to the attached drawings, in which:
FIG. 1 is a schematic perspective view of an electronic device according to an embodiment;
FIG. 2 is a perspective view of a display device included in the electronic device according to the embodiment;
FIG. 3 is a cross-sectional view of the display device of FIG. 2 viewed from a side surface;
FIG. 4 is a schematic plan view illustrating a display layer of FIG. 3;
FIG. 5 is a plan view of a plurality of pixels positioned on a display area of FIG. 4;
FIG. 6 is a schematic cross-sectional view of a pixel group in FIG. 5;
FIG. 7 is an enlarged schematic cross-sectional view of a first emission area in FIG. 6;
FIG. 8 is a schematic cross-sectional view taken along line Y1-Y1' in FIG. 4;
FIG. 9 is a schematic cross-sectional view taken along line X1-X1' in FIG. 4;
FIG. 10 is an enlarged schematic plan view of area A in FIG. 9;
FIG. 11 is a schematic cross-sectional view taken along line X1-X1' in FIG. 4 according to another embodiment;
FIG. 12 is a schematic cross-sectional view taken along line Y1-Y1' in FIG. 4 according to another embodiment;
FIG. 13 is an enlarged cross-sectional view of a pad structure in FIG. 12; and
FIGS. 14 to 22 are cross-sectional views illustrating a method of fabricating a pad structure of FIG. 9.

### DETAILED DESCRIPTION

It will be understood that, although the terms "first," "second," "third," and the like may be used herein to describe various elements, components, regions, layers and/or sections, these elements, components, regions, layers and/or sections should not be limited by these terms. These terms are used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments and is not intended to be limiting. As used herein, the singular forms "a," "an," and "the" are intended to include the plural forms, including "at least one," unless the content clearly indicates otherwise. "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as, for example, "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompass both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). The terms "about" or "approximately" can mean within one or more standard deviations, or within ± 30%, 20%, 10%, 5% of the stated value, for example.

The term "substantially," as used herein, means approximately or actually. The term "substantially equal" means approximately or actually equal. The term "substantially the same" means approximately or actually the same.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Hereinafter, embodiments of the present disclosure will be described in detail with reference to the accompanying drawings.

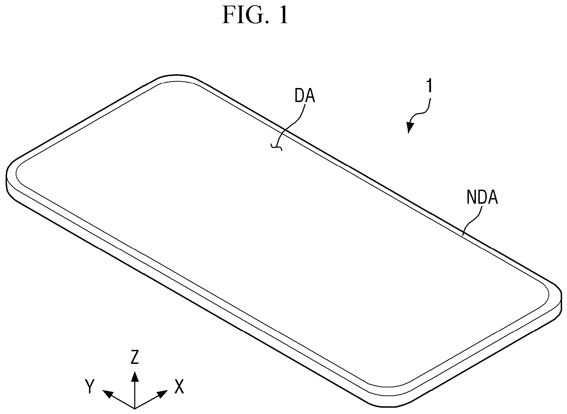

FIG. 1 is a schematic perspective view of an electronic device 1 according to an embodiment.

Referring to FIG. 1, the electronic device 1 displays moving images or still images. The electronic device 1 may refer to any electronic device that provides a display screen. Examples of the electronic device 1 may include televisions, notebook computers, monitors, billboards, Internet of things (IoT) devices, mobile phones, smartphones, tablet personal computers (PCs), electronic watches, smart watches, watch phones, head mounted displays, mobile communication terminals, electronic notebooks, electronic books, portable multimedia players (PMPs), navigation devices, game machines, digital cameras and camcorders, all of which provide a display screen.

In FIG 1, a first direction (X-axis direction), a second direction (Y-axis direction), and a third direction (Z-axis direction) are defined. The first direction (X-axis direction) and the second direction (Y-axis direction) may be perpendicular to each other, the first direction (X-axis direction) and the third direction (Z-axis direction) may be perpendicular to each other, and the second direction (Y-axis direction) and the third direction (Z-axis direction) may be perpendicular to each other. It may be understood that the first direction (X-axis direction) refers to a horizontal direction in the drawing, the second direction (Y-axis direction) refers to a vertical direction in the drawing, and the third direction (Z-axis direction) refers to an up-down direction in the drawing, that is, a thickness direction. In the following specification, unless otherwise specified, a "direction" may refer to both directions extending to both sides along the direction. In descriptions distinguishing both "directions" extending to both sides, one side will be referred to as a "first side in the direction," and the other side will be referred to as a "second side in the direction." Based on FIG. 1, a direction in which an arrow is directed will be referred to as the first side, and a direction opposite to the direction will be referred to as the second side.

Hereinafter, for ease of description, in referring to surfaces of the electronic device 1 or each member constituting the electronic device 1, one surface facing the first side in a direction in which an image is displayed, that is, in the third direction (Z-axis direction) will be referred to as an upper surface, and the other surface opposite the one surface will be referred to as a lower surface. However, embodiments of the present disclosure are not limited thereto, and the one surface and the other surface of each member may also be referred to as a front surface and a rear surface or as a first surface and a second surface, respectively. In some aspects, in describing relative positions of the members of the electronic device 1, the first side in the third direction (Z-axis direction) may be referred to as an upper side, and the second side in the third direction (Z-axis direction) may be referred to as a lower side.

The shape of the electronic device 1 can be variously modified. For example, the electronic device 1 may have various shapes such as, for example, a horizontally long rectangle, a vertically long rectangle, a square, a quadrilateral with rounded corners (vertices), other polygons, and a circle.

The electronic device 1 may include a display area DA and a non-display area NDA. The display area DA is an area where a screen can be displayed, and the non-display area NDA is an area where no screen is displayed. The display area DA may also be referred to as an active area, and the non-display area NDA may also be referred to as an inactive area. The display area DA may generally occupy a center of the electronic device 1.

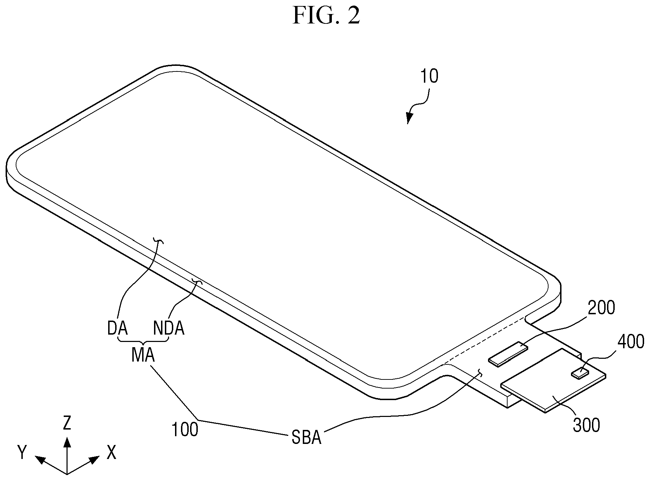

FIG. 2 is a perspective view of a display device 10 included in the electronic device 1 according to the embodiment.

Referring to FIG. 2, the electronic device 1 according to the embodiment may include the display device 10. The display device 10 may provide a screen that is displayed by the electronic device 1. The display device 10 may be, for example, an inorganic light emitting diode display device, an organic light emitting display device, a quantum dot light emitting display device, a plasma display device, or a field emission display device. A case where an organic light emitting diode display device is applied as an example of the display device 10 will be described herein, but the present disclosure is not limited to this case, and other display devices can also be applied as long as the same technical idea is applicable.

The planar shape of the display device 10 may be similar to the shape of the electronic device 1. For example, the planar shape of the display device 10 may be similar to a rectangle having short sides in the first direction (X-axis direction) and long sides in the second direction (Y-axis direction). Each corner where a short side extending in the first direction (X-axis direction) meets a long side extending in the second direction (Y-axis direction) may be rounded with a predetermined curvature. However, embodiments of the present disclosure are not limited thereto, and each corner may also be right-angled. The planar shape of the display device 10 is not limited to a quadrilateral shape but may also be similar to other polygonal shapes, a circular shape, or an oval shape.

The display device 10 may include a display panel 100, a display driver 200, a circuit board 300, and a touch driver 400.

The display panel 100 may include a main area MA and a sub-area SBA. The main area MA may include a display area DA including pixels that display an image and a non-display area NDA disposed around the display area DA.

The display area DA may emit light from a plurality of emission areas or a plurality of openings which will be described later. The non-display area NDA may be an area outside the display area DA. The non-display area NDA may be defined as an edge area of the main area MA of the display panel 100.

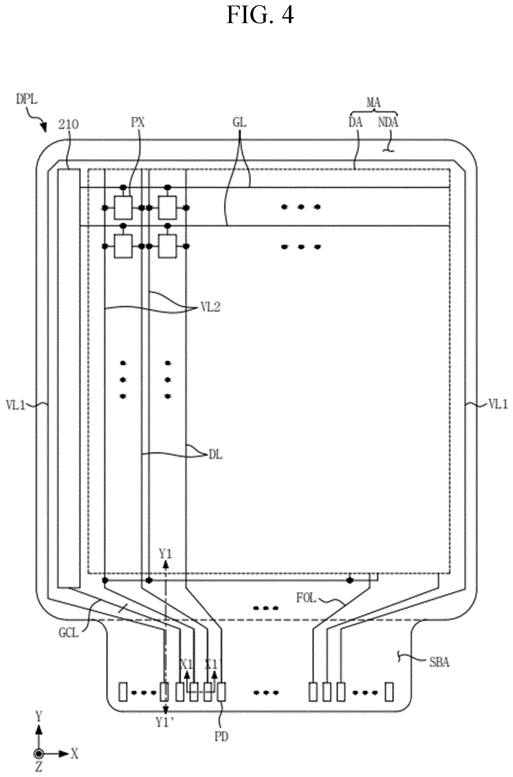

The sub-area SBA may be an area extending from a side of the main area MA. The sub-area SBA may include a flexible material that can be bent, folded, rolled, or the like. In an example in which the sub-area SBA is bent, it may be overlapped by the main area MA in the thickness direction (e.g., the third direction (Z-axis direction)). The sub-area SBA may include the display driver 200 and pad electrodes PD (see FIG. 4) connected to the circuit board 300. In an embodiment, the sub-area SBA may be omitted, and the display driver 200 and the pad electrodes PD may be located in the non-display area NDA.

The display driver 200 may output signals and voltages for driving the display panel 100. The display driver 200 may be formed as an integrated circuit and mounted on the display panel 100 using a chip on glass (COG) method, a chip on plastic (COP) method, or an ultrasonic bonding method. For example, the display driver 200 may be disposed in the sub-area SBA and may be overlapped by the main area MA in the thickness direction by the bending of the sub-area SBA. In another example, the display driver 200 may be mounted on the circuit board 300.

The circuit board 300 may be attached onto the pad electrodes PD of the display panel 100 using an anisotropic conductive film. The circuit board 300 may be electrically connected to the pad electrodes PD. The circuit board 300 may be a flexible printed circuit board, a printed circuit board, or a flexible film such as, for example, a chip on film.

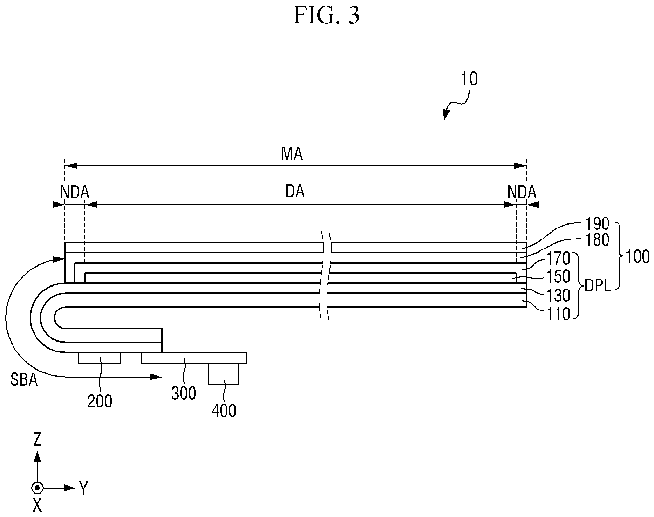

The touch driver 400 may be mounted on the circuit board 300. The touch driver 400 may be connected to a touch sensor layer 180 (see FIG. 3) of the display panel 100.

FIG. 3 is a cross-sectional view of the display device of FIG. 2 viewed from a side surface.

Referring to FIG. 3, the display panel 100 may include a display layer DPL, the touch sensor layer 180, and a color filter layer 190. The display layer DPL may include a substrate 110, a thin-film transistor layer 130, a display element layer 150, and a thin-film encapsulation layer 170.

The substrate 110 may be a base substrate or a base member. The substrate 110 may be a flexible substrate that can be bent, folded, rolled, or the like. For example, the substrate 110 may include polymer resin such as, for example, polyimide (PI). However, embodiments of the present disclosure are not limited thereto. In an embodiment, the substrate 110 may include a glass material or a metal material.

The thin-film transistor layer 130 may be disposed on the substrate 110. The thin-film transistor layer 130 may be disposed in the display area DA, the non-display area NDA, and the sub-area SBA. The thin-film transistor layer 130 may include a plurality of thin-film transistors constituting pixels PX (see FIG. 4).

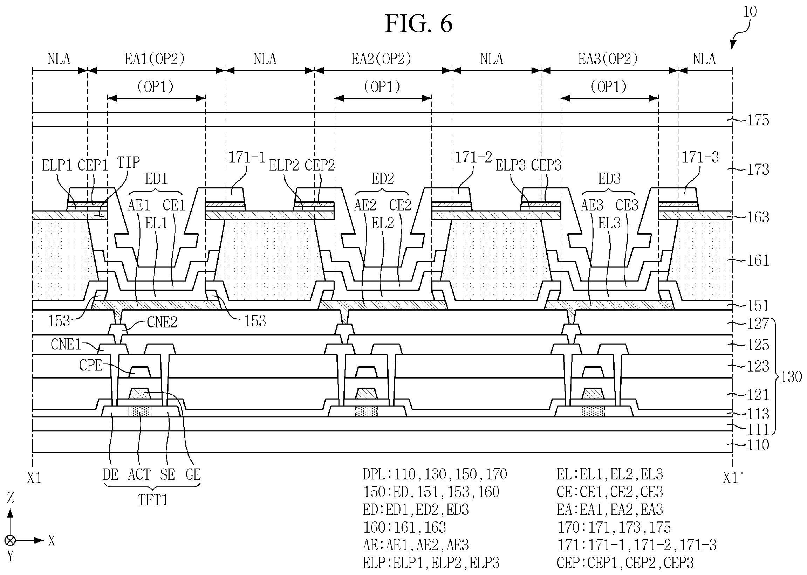

The display element layer 150 may be disposed on the thin-film transistor layer 130. The display element layer 150 may be located at a portion overlapping the display area DA. The display element layer 150 may include a plurality of light emitting elements ED (see FIG. 6). For example, each of the light emitting elements ED of an embodiment may include, but is not limited to, at least one of an organic light emitting diode including an organic light emitting layer, a quantum dot light emitting diode including a quantum dot light emitting layer, an inorganic light emitting diode including an inorganic semiconductor, and a micro-light emitting diode.

The thin-film encapsulation layer 170 may be located on the display element layer 150. The thin-film encapsulation layer 170 may be located at a portion overlapping the display area DA and the non-display area NDA. The thin-film encapsulation layer 170 may cover upper and side surfaces of the display element layer 150 and may protect the display element layer 150 from external oxygen and moisture. The thin-film encapsulation layer 170 may include at least one inorganic layer and at least one organic layer to encapsulate the display element layer 150.

The touch sensor layer 180 may be disposed on the thin-film encapsulation layer 170. The touch sensor layer 180 may be located at a portion overlapping the display area DA and the non-display area NDA. The touch sensor layer 180 may sense a user's touch using a mutual capacitance method or a self-capacitance method.

The color filter layer 190 may be disposed on the touch sensor layer 180. The color filter layer 190 may be located at a portion overlapping the display area DA and the non-display area NDA. The color filter layer 190 may absorb some of the light incident from the outside of the display device 10, thereby reducing reflected light caused by the external light. Therefore, the color filter layer 190 can prevent color distortion caused by the reflection of external light.

Since the color filter layer 190 is directly disposed on the touch sensor layer 180, the display device 10 may be implemented without a separate substrate for the color filter layer 190. For example, the display device 10 may not require a separate substrate for the color filter layer 190. Therefore, a thickness of the display device 10 may be relatively small. In some aspects, the color filter layer 190 can be omitted depending on embodiments.

As illustrated in FIG. 3, a portion of the display layer DPL which overlaps the sub-area SBA may be bent. In an example in which a portion of the display layer DPL is bent, the display driver 200, the circuit board 300, and the touch driver 400 may be overlapped by the main area MA in the third direction (Z-axis direction).

FIG. 4 is a schematic plan view illustrating a display layer DPL of FIG. 3.

Referring to FIG. 4, the display layer DPL included in an embodiment may overlap the display area DA of the main area MA and include a plurality of pixels PX, a plurality of gate lines GL, a plurality of data lines DL, and a plurality of second power lines VL2.

Each of the pixels PX may be defined as a smallest unit that emits light. The pixels PX may be described later.

The gate lines GL may supply gate signals received from the gate driver 210 to the pixels PX. The gate lines GL may extend in the first direction (X-axis direction) and may be spaced apart from each other in the second direction (Y-axis direction) intersecting the first direction (X-axis direction).

The data lines DL may supply data voltages received from the display driver 200 to the pixels PX. The data lines DL may extend in the second direction (Y-axis direction) and may be spaced apart from each other in the first direction (X-axis direction).

The second power lines VL2 may supply a power supply voltage received from the display driver 200 to the pixels PX. Here, the power supply voltage may be at least one of a driving voltage, an initialization voltage, and a reference voltage. The second power lines VL2 may extend in the second direction (Y-axis direction) and may be spaced apart from each other in the first direction (X-axis direction).

The display layer DPL included in an embodiment may overlap the non-display area NDA of the main area MA and include a first power line VL1, the gate driver 210, a plurality of fan-out lines FOL, and a gate control line GCL.

The gate driver 210 may generate a plurality of gate signals based on a gate control signal and sequentially supply the gate signals to the gate lines GL in a set order.

The first power line VL1 may be disposed in the non-display area NDA to surround the display area DA. The first power line VL1 may supply a power supply voltage received from the display driver 200 to the pixels PX. In some aspects, the first power line VL1 may be electrically connected to various lines located in the display area DA.

The fan-out lines FOL may extend from the pad electrodes PD to the display area DA. The fan-out lines FOL may supply data voltages received from the display driver 200 to the data lines DL.

The gate control line GCL may extend from the pad electrode PD to the gate driver 210. The gate control line GCL may supply a gate control signal received from the display driver 200 to the gate driver 210. Although in the example drawing illustrated at FIG. 4, the gate driver 210 is disposed in the non-display area NDA located on a left side of the display area DA, embodiments of the present disclosure are not limited thereto. In an embodiment, the display device 10 may include a plurality of gate drivers 210 disposed on left and right sides of the display area DA, respectively.

The display layer DPL included in an embodiment may include a plurality of pad electrodes PD at a portion overlapping the sub-area SBA. The plurality of pad electrodes PD may be located to be spaced apart from each other in the first direction (X-axis direction) and each of the pad electrodes PD may be connected to each of the different lines.

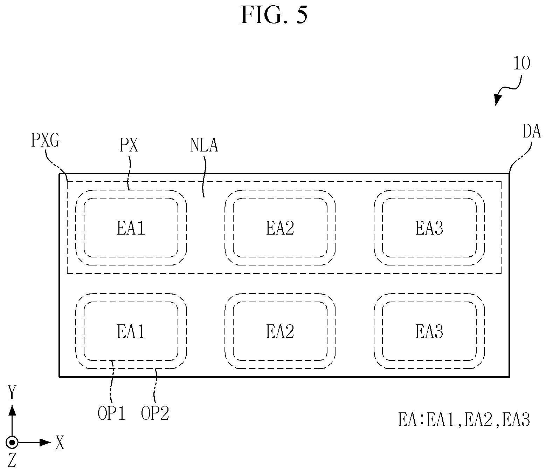

FIG. 5 is a plan view of a plurality of pixels PX positioned on a display area DA of FIG. 4.

Referring to FIG. 5, the display area DA of an embodiment may include a plurality of first through third emission areas EA1 through EA3 and a non-emission area NLA. The non-emission area NLA may surround the first through third emission areas EA1 through EA3.

The non-emission area NLA may block light emitted from each of the first through third emission areas EA1 through EA3. Therefore, the non-emission area NLA may help prevent the color mixing of light emitted from the first through third emission areas EA1 through EA3.

The emission areas EA may include the first emission areas EA1, the second emission areas EA2, and the third emission areas EA3 which emit light of different colors. Each of the first through third emission areas EA1 through EA3 may emit red, green, or blue light. The color of light emitted from each of the first through third emission areas EA1 through EA3 may vary according to the type of light emitting element ED (see FIG. 6) which will be described later. For example, the first emission areas EA1 may emit red light of a first color, the second emission areas EA2 may emit green light of a second color, and the third emission areas EA3 may emit blue light of a third color, but embodiments of the present disclosure are not limited thereto. Although the first through third emission areas EA1 through EA3 have the same size and shape in the drawing, embodiments of the present disclosure are not limited thereto. The size and shape of each of the first through third emission areas EA1 through EA3 can be freely adjusted according to desired characteristics (e.g., required characteristics).

The emission area EA may be defined by first openings OP1 and second openings OP2. The second openings OP2 may completely surround the first openings OP1 in a plan view. The second openings OP2 may be completely surrounded by the non-emission area NLA in a plan view.

In some embodiments, at least one first emission area EA1, at least one second emission area EA2, and at least one third emission area EA3 disposed adjacent to each other may form one pixel group PXG. The pixel group PXG may be a smallest unit that emits white light. However, the types and/or number of the first through third emission areas EA1 through EA3 constituting the pixel group PXG may vary according to embodiments.

FIG. 6 is a schematic cross-sectional view of a pixel group PXG in FIG. 5. FIG. 6 illustrates a schematic cross-section of the display layer DPL overlapping the display area DA. That is, FIG. 6 illustrates cross-sections of the substrate 110, the thin-film transistor layer 130, the display element layer 150, and the thin-film encapsulation layer 170 of the display device 10 according to an embodiment. Since the substrate 110 has already been mentioned, a redundant description thereof will be omitted.

Referring to FIG. 6, the thin-film transistor layer 130 may be located on the substrate 110. The thin-film transistor layer 130 may include a first buffer layer 111, first thin-film transistors TFT1, a gate insulating layer 113, a first insulating layer 121, capacitor electrodes CPE, a second insulating layer 123, first connection electrodes CNE1, a first via layer 125, second connection electrodes CNE2, and a second via layer 127.

The first buffer layer 111 may be disposed on the substrate 110. The first buffer layer 111 may include an inorganic layer that can prevent the penetration of air or moisture. For example, the first buffer layer 111 may include a plurality of inorganic layers stacked alternately.

The first thin-film transistors TFT1 may be disposed on the first buffer layer 111 and may constitute pixel circuits respectively connected to a plurality of pixels. For example, each of the first thin-film transistors TFT1 may be a driving transistor or a switching transistor of a pixel circuit. Each of the first thin-film transistors TFT1 may include an active layer ACT, a source electrode SE, a drain electrode DE, and a gate electrode GE.

The active layer ACT may be disposed on the first buffer layer 111. The active layer ACT may be overlapped by the gate electrode GE in the third direction (Z-axis direction) and may be insulated from the gate electrode GE by the gate insulating layer 113. The material of the active layer ACT may be made conductive in portions of the active layer ACT and form the source electrode SE and the drain electrode DE.

The gate electrode GE may be disposed on the gate insulating layer 113. The gate electrode GE may overlap the active layer ACT, with the gate insulating layer 113 interposed between the gate electrode GE and the active layer ACT.

The gate insulating layer 113 may be disposed on the active layers ACT. The gate insulating layer 113 may cover the active layers ACT and the first buffer layer 111 and may insulate the active layers ACT from the gate electrodes GE. The gate insulating layer 113 may include contact holes through which the first connection electrodes CNE1 pass.

The first insulating layer 121 may cover the gate electrodes GE and the gate insulating layer 113. The first insulating layer 121 may include contact holes through which the first connection electrodes CNE1 pass. The contact holes of the first insulating layer 121 may be connected to the contact holes of the gate insulating layer 113 and contact holes of the second insulating layer 123.

The capacitor electrodes CPE may be disposed on the first insulating layer 121. The capacitor electrodes CPE may overlap the gate electrodes GE in the third direction (Z-axis direction). The capacitor electrodes CPE and the gate electrodes GE may form capacitance.

The second insulating layer 123 may cover the capacitor electrodes CPE and the first insulating layer 121. The second insulating layer 123 may include the contact holes through which the first connection electrodes CNE1 pass. The contact holes of the second insulating layer 123 may be connected to the contact holes of the first insulating layer 121 and the contact holes of the gate insulating layer 113.

The first connection electrodes CNE1 may be disposed on the second insulating layer 123. The first connection electrodes CNE1 may electrically connect the drain electrodes DE of the first thin-film transistors TFT1 to the second connection electrodes CNE2. The first connection electrodes CNE1 may be inserted into the contact holes formed in the first insulating layer 121, the second insulating layer 123 and the gate insulating layer 113 and contact the drain electrodes DE of the first thin-film transistors TFT1.

The first via layer 125 may cover the first connection electrodes CNE1 and the second insulating layer 123. The first via layer 125 may flatten structures under the first via layer 125. The first via layer 125 may include contact holes through which the second connection electrodes CNE2 pass.

The first via layer 125 may include an organic insulating material. For example, the first via layer 125 may use an acrylic resin, polyimide, polyamide, benzocyclobutene, and a phenolic resin.

The second connection electrodes CNE2 may be disposed on the first via layer 125. The second connection electrodes CNE2 may be inserted into the contact holes formed in the first via layer 125 and contact the first connection electrodes CNE1. The second connection electrodes CNE2 may electrically connect the first connection electrodes CNE1 to anodes AE.

The second via layer 127 may cover the second connection electrodes CNE2 and the first via layer 125. The second via layer 127 may include contact holes through which the anodes AE pass.

The second via layer 127 may include an organic insulating material. For example, the second via layer 127 may include the same material as the first via layer 125.

The display element layer 150 may be disposed on the thin-film transistor layer 130. The display element layer 150 may include light emitting elements ED, a pixel defining layer 151, residual patterns 153, and the bank structure 160.

Each of the light emitting elements ED may include an anode AE, a light emitting layer EL, and a cathode CE. The light emitting elements ED may include a first light emitting element ED1 disposed in a first emission area EA1, a second light emitting element ED2 disposed in a second emission area EA2, and a third light emitting element ED3 disposed in a third emission area EA3.

The first through third light emitting elements ED1 through ED3 may emit light of different colors depending on the materials of first through third light emitting layers EL1 through EL3. For example, the first light emitting element ED1 may emit red light of the first color, the second light emitting element ED2 may emit green light of the second color, and the third light emitting element ED3 may emit blue light of the third color.

The anodes AE according to an embodiment may be disposed on the second via layer 127. The anodes AE may be electrically connected to the drain electrodes DE of the first thin-film transistors TFT1 through the first connection electrodes CNE1 and the second connection electrodes CNE2.

The anodes AE may include a first anode AE1 disposed in the first emission area EA1, a second anode AE2 disposed in the second emission area EA2, and a third anode AE3 disposed in the third emission area EA3. The first anode AE1, the second anode AE2, and the third anode AE3 may be spaced apart from each other on the second via layer 127.

In an embodiment, the anodes AE may have a stacked structure of a material layer having a high work function such as, for example, indium-tin-oxide (ITO), indium-zinc-oxide (IZO), zinc oxide (ZnO) or indium oxide (In₂O₃) and a reflective material layer such as, for example, silver (Ag), magnesium (Mg), aluminium (Al), platinum (Pt), lead (Pb), palladium (Pd), gold (Au), nickel (Ni), neodymium (Nd), iridium (Ir), chromium (Cr), lithium (Li), or a mixture thereof. For example, the anodes AE may have, but are not limited to, a multilayer structure of ITO/Mg, ITO/MgF, ITO/Ag, or ITO/Ag/ITO.

The pixel defining layer 151 of an embodiment may be located on the second via layer 127 and the anodes AE. As described herein, the pixel defining layer 151 may define the first openings OP1 that form the emission areas EA. The pixel defining layer 151 may be disposed on the entire surface of the second via layer 127, but may partially expose upper surfaces of the anodes AE. For example, the pixel defining layer 151 may expose the anodes AE in portions overlapping the first openings OP1, and the light emitting layers EL may be directly disposed on the anodes AE in the portions overlapping the first openings OP1.

The pixel defining layer 151 may include an inorganic insulating material. For example, the pixel defining layer 151 may include aluminium oxide, titanium oxide, tantalum oxide, hafnium oxide, zinc oxide, silicon oxide, silicon nitride, or silicon oxynitride.

The bank structure 160 of an embodiment may be located on the pixel defining layer 151. The bank structure 160 may define the second openings OP2, and the light emitting elements ED of the display device 10 may overlap the second openings OP2. The bank structure 160 may include a first bank layer 161 and a second bank layer 163 including different metal materials and structures and playing different roles. The bank structure 160 will be described later.

The light emitting layers EL of an embodiment may be disposed on the anodes AE. The light emitting layers EL may be organic light emitting layers formed of an organic material and may be formed on the anodes AE through a deposition process. When a first thin-film transistor TFT1 applies a predetermined voltage to an anode AE and a cathode CE receives a common voltage or a cathode voltage, holes and electrons may move to a light emitting layer EL through a hole transport layer and an electron transport layer, respectively, and may be combined with each other in the light emitting layer EL to emit light.

The light emitting layers EL may include the first light emitting layer EL1 disposed in the first emission area EA1, the second light emitting layer EL2 disposed in the second emission area EA2, and the third light emitting layer EL3 disposed in the third emission area EA3. For example, the first light emitting layer EL1 may be a light emitting layer that emits red light of the first color, the second light emitting layer EL2 may be a light emitting layer that emits green light of the second color, and the third light emitting layer EL3 may be a light emitting layer that emits blue light of the third color. However, embodiments of the present disclosure are not limited thereto.

In some embodiments, the anodes AE may be spaced apart from the pixel defining layer 151 in the third direction (Z-axis direction). The light emitting layers EL and the residual patterns 153 may be located between the anodes AE and the pixel defining layer 151 spaced apart from each other. The residual patterns 153 may be residues of a temporary protective layer which is temporarily formed on the anodes AE and then removed during a process of fabricating the display device 10. Details will be described herein.

The cathodes CE may include a transparent conductive material to transmit light generated from the light emitting layers EL. The cathodes CE may receive a common voltage or a low-potential voltage. When an anode AE receives a voltage corresponding to a data voltage and a cathode CE receives a low-potential voltage, a potential difference may be formed between the anode AE and the cathode CE. Accordingly, a light emitting layer EL may emit light.

In an embodiment, the cathodes CE may include a material layer having a small work function such as, for example, Li, Ca, LiF/Ca, LiF/Al, Al, Mg, Ag, Pt, Pd, Ni, Au Nd, Ir, Cr, BaF, Ba, or a compound or mixture thereof (e.g., a mixture of Ag and Mg). The cathodes CE may further include a transparent metal oxide layer disposed on the material layer having a small work function.

The cathodes CE may include a first cathode CE1, a second cathode CE2, and a third cathode CE3 disposed in the first emission area EA1, the second emission area EA2, and the third emission area EA3, respectively. The first cathode CE1 may be disposed on the first light emitting layer EL1 in the first emission area EA1, the second cathode CE2 may be disposed on the second light emitting layer EL2 in the second emission area EA2, and the third cathode CE3 may be disposed on the third light emitting layer EL3 in the third emission area EA3.

The first cathode CE1, the second cathode CE2, and the third cathode CE3 may be spaced apart from each other. The cathodes CE spaced apart from each other may not be directly connected but may be electrically connected through the first bank layer 161 of the bank structure 160.

The organic pattern ELP of an embodiment may be located on the second bank layer 163. The organic pattern ELP may be disposed to surround the periphery of the first opening OP1. The organic pattern ELP may include the same material as the light emitting layer EL. The organic pattern ELP may include a first organic pattern ELP1 surrounding the first light emitting element ED1, a second organic pattern ELP2 surrounding the second light emitting element ED2, and a third organic pattern ELP3 surrounding the third light emitting element ED3. For example, the first organic pattern ELP1 may include the same material as the first light emitting layer EL1, the second organic pattern ELP2 may include the same material as the second light emitting layer EL2, and the third organic pattern ELP3 may include the same material as the third light emitting layer EL3. The organic pattern ELP may be a trace formed as the light emitting layer EL is disconnected by a tip TIP included in the bank structure 160.

The electrode pattern CEP of an embodiment may be located on the second bank layer 163. The electrode pattern CEP may be disposed to surround the periphery of the first opening OP1. The electrode pattern CEP may include the same material as the cathode electrode CE. The electrode pattern CEP may include a first electrode pattern CEP1 surrounding the first light emitting element ED1, a second electrode pattern CEP2 surrounding the second light emitting element ED2, and a third electrode pattern CEP3 surrounding the third light emitting element ED3. For example, the first electrode pattern CEP1 may include the same material as the first cathode electrode CE1, the second electrode pattern CEP2 may include the same material as the second cathode electrode CE2, and the third electrode pattern CEP3 may include the same material as the third cathode electrode CE3. The electrode pattern CEP may be a trace formed as the cathode electrode CE is disconnected by the tip TIP included in the bank structure 160.

The thin-film encapsulation layer 170 may be disposed on the display element layer 150. The thin-film encapsulation layer 170 may include at least one inorganic layer to prevent oxygen or moisture from penetrating into the display element layer 150. The thin-film encapsulation layer 170 may include at least one organic layer to protect the display element layer 150 from foreign substances such as, for example, dust.

In an embodiment, the thin-film encapsulation layer 170 may include a first encapsulation layer 171, a second encapsulation layer 173, and a third encapsulation layer 175 stacked sequentially. The first encapsulation layer 171 and the third encapsulation layer 175 may be inorganic encapsulation layers, and the second encapsulation layer 173 disposed between the first encapsulation layer 171 and the third encapsulation layer 175 may be an organic encapsulation layer.

The first encapsulation layer 171 of an embodiment may include first through third inorganic layers 171-1 through 171-3. The first through third inorganic layers 171-1 through 171-3 may cover the light emitting elements ED and the bank structure 160. The first through third inorganic layers 171-1 through 171-3 may be formed through a chemical vapor deposition (CVD) process. Therefore, the first through third inorganic layers 171-1 through 171-3 may be formed to a uniform thickness along the profiles of structures under the first through third inorganic layers 171-1 through 171-3.

The first through third inorganic layers 171-1 through 171-3 may be respectively located at portions overlapping the first through third emission areas EA1 through EA3. For example, the first inorganic layer 171-1 may cover the first cathode CE1 and the first electrode pattern CEP1 at a portion overlapping the first emission area EA1, the second inorganic layer 171-2 may cover the second cathode CE2 and the second electrode pattern CEP2 at a portion overlapping the second emission area EA2, and the third inorganic layer 171-3 may cover the third cathode CE3 and the third electrode pattern CEP3 at a portion overlapping the third emission area EA3. The first through third inorganic layers 171-1 through 171-3 may expose the bank structure 160 and may be spaced apart from each other at a portion overlapping the non-emission area NLA.

Although the first through third inorganic layers 171-1 through 171-3 are formed on the same layer in the drawing, they may be formed in different processes. For example, the first inorganic layer 171-1 may be formed after the first cathode CE1 is formed, the second inorganic layer 171-2 may be formed after the second cathode CE2 is formed, and the third inorganic layer 171-3 may be formed after the third cathode CE3 is formed.

The first encapsulation layer 171 may include one or more inorganic insulating materials. The inorganic insulating materials may include aluminium oxide (Al₂O₃), titanium oxide (Ti₂O₃), tantalum oxide (Ta₂O₅), hafnium oxide (HfO₂), zinc oxide (ZnO), silicon oxide (SiO₂), silicon nitride (Si₃N₄), and silicon oxynitride (Si₂N₂O).

The second encapsulation layer 173 may be located on the first encapsulation layer 171. The second encapsulation layer 173 may flatten steps formed by the first encapsulation layer 171.

The second encapsulation layer 173 may include a polymer-based material. Examples of the polymer-based material may include acrylic resin, epoxy resin, polyimide, and polyethylene. For example, the second encapsulation layer 173 may include acrylic resin such as, for example, polymethyl methacrylate or polyacrylic acid. The second encapsulation layer 173 may be formed by curing a monomer or applying a polymer.

The third encapsulation layer 175 may be located on the second encapsulation layer 173. The third encapsulation layer 175 may include the same material as the first encapsulation layer 171. The third encapsulation layer 175 may prevent oxygen or moisture from penetrating into the second encapsulation layer 173.

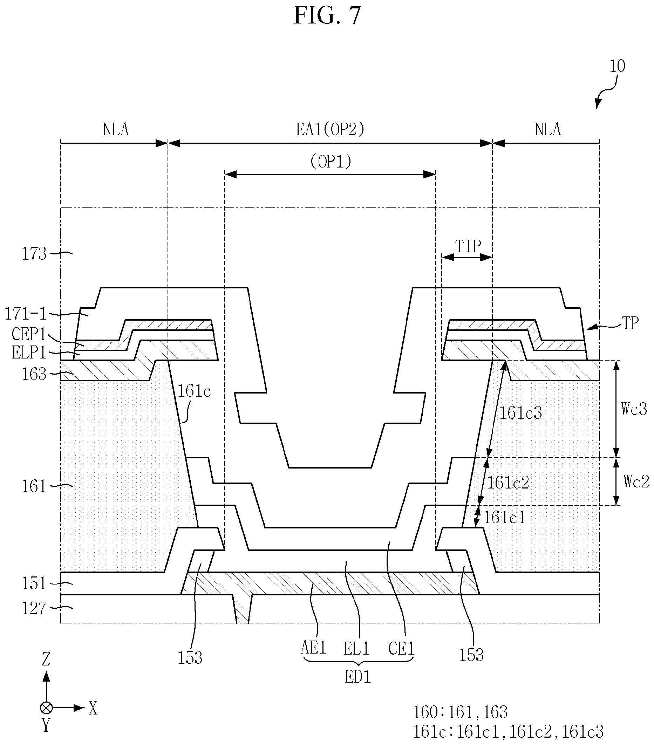

FIG. 7 is an enlarged schematic cross-sectional view of the first emission area EA1 in FIG. 6.

Referring to FIG. 7, the pixel defining layer 151 of an embodiment may be spaced apart from the first anode AE1 in the third direction (Z-axis direction), and a residual pattern 153 may be located between the pixel defining layer 151 and the first anode AE1. The residual pattern 153 may contact both sides of the first light emitting layer EL1 in the first direction (X-axis direction). In some aspects, the residual pattern 153 may be overlapped by the tips TIP of the bank structure 160 in the third direction (Z-axis direction).

The bank structure 160 of an embodiment may include the first bank layer 161 and the second bank layer 163 including different metal materials and structures and playing different roles.

The first bank layer 161 may be located on the pixel defining layer 151 and contact the pixel defining layer 151. The first bank layer 161 may include a metal having high electrical conductivity, for example, aluminium (Al).

In some embodiments, the first bank layer 161 may include side surfaces 161c facing a first opening OP1. The side surfaces 161c of the first bank layer 161 may be inclined surfaces. In other words, the side surfaces 161c of the first bank layer 161 may be inclined between the first direction (X-axis direction) and the third direction (Z-axis direction). That is, each of the side surfaces 161c of the first bank layer 161 may include a structure that is more recessed than the pixel defining layer 151 in the first direction (X-axis direction).

The first light emitting layer EL1 and the first cathode CE1 may contact the side surfaces 161c of the first bank layer 161 of an embodiment. In the display device 10 of the embodiment, since the bank structure 160 includes the tips TIP, the first light emitting layer EL1 and the first cathode CE1 can be formed through deposition and photo pattern processes without using a fine metal mask in a manufacturing process. Therefore, the first light emitting layer EL1 and the first cathode CE1 may contact the side surfaces 161c of the first bank layer 161 in a portion overlapping the second opening OP2.

The first cathode CE1 of an embodiment may cover more of the side surfaces 161c of the first bank layer 161 than the first light emitting layer EL1. As described herein, the first cathode CE1 and the first bank layer 161 may be electrically connected. As the area of contact between the first cathode CE1 and each side surface 161c of the first bank layer 161 increases, the electrical resistance of the display device 10 may decrease.

In some embodiments, each side surface 161c of the first bank layer 161 may include a first part 161c1, a second part 161c2, and a third part 161c3 depending on a structure contacting. The first part 161c1 may be a part in contact with the first light emitting layer EL1, the second part 161c2 may be a part in contact with the first cathode CE1, and the third part 161c3 may be a part in contact with the first inorganic layer 171-1.

The second part 161c2 may be disposed between the first part 161c1 and the third part 161c3, and the area Wc2 of the second part 161c2 may be adjusted according to a method of fabricating the first cathode CE1. As the area Wc2 of the second part 161c2 is adjusted, the area Wc3 of the third part 161c3 may also be adjusted. In an example in which the area Wc2 of the second part 161c2 increases, the area Wc3 of the third part 161c3 may decrease.

The second bank layer 163 of an embodiment may be located on the first bank layer 161. The second bank layer 163 may include a material having a lower etch rate than that of the first bank layer 161. For example, the second bank layer 163 may include titanium (Ti). The second bank layer 163 may have the tips TIP that protrude more than the side surfaces 161c of the first bank layer 161 toward the first emission area EA1. Since the second bank layer 163 includes the tips TIP in the display device 10 according to the embodiment, the first light emitting element ED1 may be formed without a fine metal mask in the process of fabricating the display device 10. Other redundant descriptions will be omitted.

The first organic pattern ELP1 of an embodiment may be located on the second bank layer 163. The first organic pattern ELP1 may be located in portions overlapping the protruding tips TIP of the second bank layer 163 within the second opening OP2. In some aspects, the first organic pattern ELP1 may cover the second bank layer 163 in a portion overlapping a portion of the non-emission area NLA.

In the fabrication process of the display device 10, the first organic pattern ELP1 may be formed such that the first organic pattern ELP1 covers the entire surface of the second bank layer 163 and then may be partially etched in a subsequent etching process. Accordingly, trench portions TP may be formed on side surfaces of the etched first organic pattern ELP1, and the trench portions TP may be covered by the second encapsulation layer 173.

The first electrode pattern CEP1 may be located on the first organic pattern ELP1. The first electrode pattern CEP1 may be located in the portions overlapping the protruding tips TIP of the second bank layer 163 within the second opening OP2. In some aspects, the first electrode pattern CEP1 may cover the first organic pattern ELP1 in the portion overlapping the non-emission area NLA.

In the fabrication process of the display device 10, the first electrode pattern CEP1 may be formed such that the first electrode pattern CEP1 covers the entire surface of the first organic pattern ELP1 and then may be partially etched in a subsequent etching process. Accordingly, the trench portions TP may be formed on side surfaces of the etched first electrode pattern CEP1, and the trench portions TP may be covered by the second encapsulation layer 173.

The first inorganic layer 171-1 of an embodiment may cover the first light emitting element ED1 and the first electrode pattern CEP1. The first inorganic layer 171-1 may be disposed within the second opening OP2 and contact the first cathode CE1 and the side surfaces 161c of the first bank layer 161 and cover the protruding tips TIP of the second bank layer 163. In some aspects, the first inorganic layer 171-1 may cover the first electrode pattern CEP1 in the portion overlapping the non-emission area NLA.

In the fabrication process of the display device 10, the first inorganic layer 171-1 may be formed such that the first inorganic layer 171-1 covers the entire surface of the first electrode pattern CEP1 and then may be partially etched in a subsequent etching process. Accordingly, the trench portions TP may be formed in the etched portions of the first inorganic layer 171-1, and the trench portions TP may be covered by the second encapsulation layer 173.

In other words, it can be seen that, since the first organic pattern ELP1, the first electrode pattern CEP1, and the first inorganic layer 171-1 of an embodiment include trench portions TP at a portion overlapping the non-emission area NLA, the etching process of removing a portion in the manufacturing process of the display device 10 in included.

The second encapsulation layer 173 may flatten steps formed by the first inorganic layer 171-1 in a portion overlapping the first opening OP1 and may cover the first inorganic layer 171-1 and the second bank layer 163 in portions overlapping the second opening OP2 and the non-emission area NLA. Other redundant descriptions will be omitted.

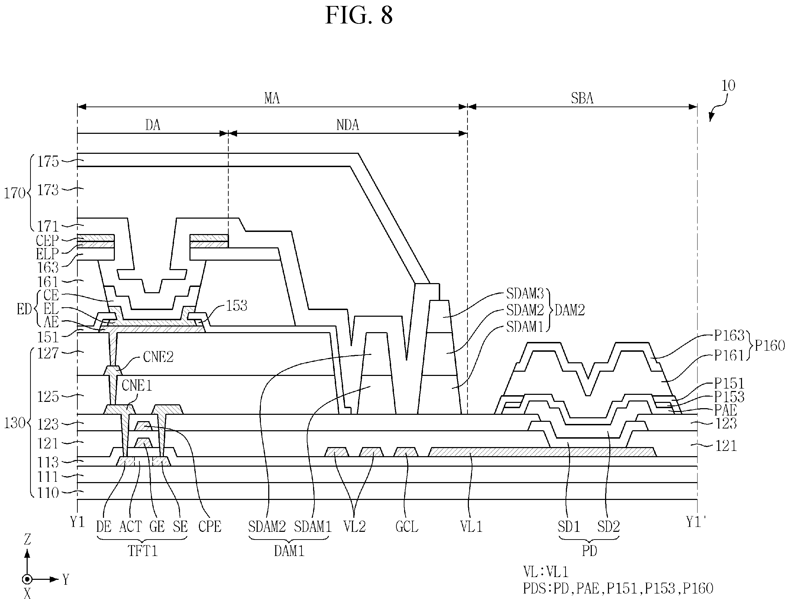

FIG. 8 is a schematic cross-sectional view taken along line Y1-Y1' in FIG. 4. Since a structure located at a portion overlapping in the display area DA in FIG. 8 is described in FIGS. 6 and 7, a repeated description thereof will be omitted. Hereinafter, the structure overlapping the non-display area NDA and the sub-area SBA will be described.

Referring to FIG. 8, the display area 10 may include a first dam DAM1 and a second dam DAM2 at a portion overlapping the non-display area NDA. The first dam DAM1 and the second dam DAM2 may be disposed to surround the display area DA. The first dam DAM1 and the second dam DAM2 may prevent the second encapsulation layer 173 of the thin-film encapsulation layer 170 from overflowing into the sub-area SBA.

The first dam DAM1 may include a first sub-dam SDAM1 and a second sub-dam SDAM2, and the second dam DAM2 may include a first sub-dam SDAM1, a second sub-dam SDAM2, and a third sub-dam SDAM3. The first sub-dam SDAM1 may include the same material as the first via layer 125, and may be disposed on the same layer. The second sub-dam SDAM2 may include the same material as the second via layer 127, and may be disposed on the same layer. The third sub-dam SDAM3 may be disposed on the second sub-dam SDAM2, and include the same material as the pixel defining layer 151 and may be disposed on the same layer.

The height of the first dam DAM1 may be lower than the height of the second dam DAM2, but is not limited thereto. The height of the first dam DAM1 may be substantially the same as the height of the second dam DAM2 or may be higher than the height of the second dam DAM2.

The first encapsulation layer 171 and the third encapsulation layer 175 of an embodiment may cover the first dam DAM1 and the second dam DAM2. Although the first encapsulation layer 171 and the third encapsulation layer 175 as illustrated in the example of FIG. 8 cover a portion of the second dam DAM2 in the drawing, embodiments of the present disclosure are not limited thereto. Depending on the manufacturing process, the first encapsulation layer 171 and the third encapsulation layer 175 may extend to a portion overlapping the sub-area SBA passing through the first dam DAM1 and the second dam DAM2.

The second encapsulation layer 173 of an embodiment may be disposed to cover the upper surface of the first dam DAM1 but not cover the upper surface of the second dam DAM2. However, embodiments of the present disclosure are not limited thereto, and the second encapsulation layer 173 may not completely cover the upper surfaces of the first dam DAM1 and the second dam DAM2. As described herein, due to the first dam DAM1 and the second dam DAM2, the second encapsulation layer 173 may not overflow into the sub-area SBA.

The first power line VL1 of an embodiment may be located on the gate insulating layer 113 at a portion overlapping the non-display area NDA and the sub-area SBA. The first power line VL1 may be disposed on the same layer as the gate electrode GE of the thin-film transistor layer 130 and include the same material.

A portion of the first power line VL1 may be covered by the first insulating layer 121. However, the portion of the first power line VL1 at a portion overlapping the pad structure PDS may be exposed by a contact hole passing through the first insulating layer 121. The exposed portion of the first power line VL1 may be in contact with the pad electrode PD. Accordingly, the first power line VL1 may be electrically connected to the pad electrode PD.

The gate control line GCL and the second power line VL2 of an embodiment may be located on the gate insulating layer 113 at a portion overlapping the non-display area NDA. The gate control line GCL and the second power line VL2 may be disposed on the same layer as the gate electrode GE of the thin-film transistor layer 130 and may include a conductive metal material.

Although a cross-sectional view of a portion where the first power line VL1 is in contact with the pad electrode PD is illustrated and described in the drawing, lines such as, for example, the gate control line GCL, the second power line VL2, and the data line DL may also be electrically connected to the pad electrode PD depending on the location of the cut cross-section.

The pad structure PDS of an embodiment may be located to be spaced apart from the second dam DAM2 in the second direction (Y-axis direction). Accordingly, the second encapsulation layer 173 of an embodiment may not overlap the pad structure PDS. The pad structure PDS will be described herein.

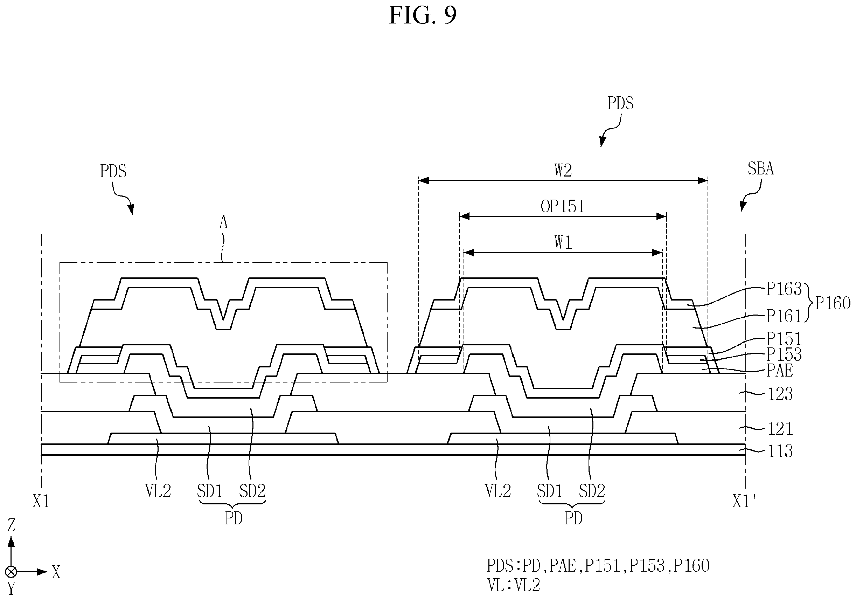

FIG. 9 is a schematic cross-sectional view taken along line X1-X1' in FIG. 4. FIG. 8 illustrates a cross-sectional view of a pad structure PDS cut in the second direction (Y-axis direction), and FIG. 9 illustrates a cross-sectional view of a pad structure PDS cut in the first direction (X-axis direction).

Referring to FIGS. 8 and 9, the pad structure PDS of an embodiment may be formed in plural numbers. Each of the pad structures PDS may be separated or spaced apart from each other in the first direction (X-axis direction) at a portion overlapping the sub-area SBA.

The pad structure PDS of an embodiment may include a pad electrode PD, a pad anode electrode PAE, a pad inorganic layer P151, a pad residual pattern P153, and a pad bank structure P160. The pad electrode PD of an embodiment may include a first pad electrode SD1 and a second pad electrode SD2, and the pad bank structure P160 may include a first pad bank layer P161 and a second pad bank layer P163.

The first pad electrode SD1 of an embodiment may be disposed on the same layer as the capacitor electrode CPE and may include the same material. The first pad electrode SD1 may be disposed on the first insulating layer 121 and be in direct contact with the power line VL through a contact hole passing through the first insulating layer 121.

The first pad electrode SD1 may include a conductive metal and, for example, may be a single layer or a multilayer formed of any one or more of molybdenum (Mo), aluminium (Al), chromium (Cr), gold (Au), titanium (Ti), nickel (Ni), neodymium (Nd), copper (Cu), and alloys of the same.

The second pad electrode SD2 of an embodiment may be disposed on the same layer as the first connection electrode CNE1 and may include a same material as the first connection electrode CNE1. The second pad electrode SD2 may be disposed on the second insulating layer 123 and be in direct contact with the first pad electrode SD1 through a contact hole passing through the second insulating layer 123.

The second pad electrode SD2 may include a conductive metal and, for example, may be a single layer or a multilayer formed of any one or more of molybdenum (Mo), aluminium (Al), chromium (Cr), gold (Au), titanium (Ti), nickel (Ni), neodymium (Nd), copper (Cu), and alloys of the same.

Although the first pad electrode SD1 and the second pad electrode SD2 are illustrated to be separated in the drawing and described accordingly, embodiments of the present disclosure are not limited thereto. According to an embodiment, the first pad electrode SD1 and the second pad electrode SD2 may be formed as one.

In some embodiments, the second pad electrode SD2 may have a first width W1 in the first direction (X-axis direction). According to an embodiment, the first width W1 may refer to as a width of the first pad electrode SD1. That is, the first width W1 may mean a width of the pad electrode PD.

The pad anode electrode PAE of an embodiment may be located on the pad electrode PD. The pad anode electrode PAE may be located on the second insulating layer 123 and be in direct contact with the second pad electrode SD2 through a contact hole passing through the second insulating layer 123. The pad anode electrode PAE and the pad electrode PD may be electrically connected.

The pad anode electrode PAE of an embodiment may be formed in an island shape at a portion overlapping each of the pad structures PDS. That is, the pad anode electrodes PAE of an embodiment may be formed to be spaced apart and separated at a portion overlapping each of the pad structures PDS.

The pad anode electrode PAE may entirely cover the pad electrode PD, and be in entire contact with the pad anode electrode PAE. In some aspects, the pad anode electrode PAE may cover a portion of the second insulating layer 123, and may be in contact with the portion of the second insulating layer 123. Since the pad anode electrode PAE of an embodiment may completely cover the pad electrode PD, penetration of moisture from etching byproducts into the pad anode electrode PAE caused during the manufacturing process may be prevented. Accordingly, the display device 10 of an embodiment may solve short-circuit defects of the pad electrode PD caused by the etching byproducts during the manufacturing process. The manufacturing process will be described herein.

During the manufacturing process of the display device 10, the pad anode electrode PAE of an embodiment may be formed in the same process as the anode electrode AE located at a portion overlapping the display area DA. In other words, the display device 10 may form the pad anode electrode PAE by executing the process executed in the display area DA, in the sub-area SBA, without additional process. Accordingly, the pad structure PDS of an embodiment may have ease of manufacturing.

The pad anode electrode PAE of an embodiment may include the same material as the anode electrode AE. For example, the anode electrode PAE may include a transparent oxide electrode (TCO) such as, for example, indium-tin-oxide (ITO), indium-zinc-oxide (IZO), zinc oxide (ZnO) or indium oxide (In₂O₃).

In some embodiments, the pad anode electrode PAE may have a second width W2 in the first direction (X-axis direction). In some embodiments, the second width W2 included in the pad anode electrode PAE may be larger than the first width W1 included in the pad electrode PD. That is, in cross-sectional view, the pad anode electrode PAE may completely cover the pad electrode PD.

The pad residual pattern P153 of an embodiment may be located on the pad anode electrode PAE. The pad residual pattern P153 may expose the central portion of the pad anode electrode PAE and cover the edges of the pad anode electrode PAE. In other words, the pad residual pattern P153 may surround a third opening OP151 defined by the pad inorganic layer P151.

The pad residual pattern P153 of an embodiment covers the edges of the pad anode electrode PAE, thereby preventing etching byproducts from permeating into the pad electrode PD caused during the manufacturing process of the display device 10. Accordingly, the pad residual pattern P153 of an embodiment may solve short-circuit defects of the pad electrode PD caused during the manufacturing process.

In some aspects, the pad residual pattern P153 of an embodiment is located on the edge of the pad anode electrode PAE, thereby alleviating the step (i.e., reducing step height) of a portion overlapping the edge of the pad bank structure P160 when the pad bank structure P160 is formed in the subsequent process.

The pad residual pattern P153 of an embodiment may be formed in the same process as the residual pattern 153 located in the display area DA. In other words, the display device 10 may form the pad residual pattern P153 by executing the process executed in the display area DA, in the sub-area SBA, without additional process. Accordingly, the pad structure PDS of an embodiment may also have ease of manufacturing.

The pad residual pattern P153 of an embodiment may include the same material as the residual pattern 153 located in the display area DA. For example, the pad residual pattern P153 may include a transparent oxide electrode (TCO) such as, for example, indium-tin-oxide (ITO), indium-zinc-oxide (IZO), zinc oxide (ZnO) or indium oxide (In₂O₃).

In some embodiments, the pad residual pattern P153 included in the display device 10 may be completely surrounded by the pad anode electrode PAE and the pad inorganic layer P151. In some aspects, the pad residual pattern P153 included in the display device 10 may be in entire contact with the pad anode electrode PAE and the pad inorganic layer P151.

The pad inorganic layer P151 of an embodiment may be located on the pad residual pattern P153. The pad inorganic layer P151 may define the third opening OP151 and surround the third opening OP151 to cover the edge of the pad anode electrode PAE. The pad inorganic layer P151 of an embodiment may be in contact with the second insulating layer 123, and the pad inorganic layer P151 may extend to and be in contact with the pad anode electrode PAE and the pad residual pattern P153. As described herein, the pad residual pattern P153 of an embodiment may be completely covered by the pad inorganic layer P151.

The pad inorganic layer P151 of an embodiment covers the edge of the pad anode electrode PAE, thereby preventing etching byproducts from permeating into the pad electrode PD caused during the manufacturing process of the display device 10. Accordingly, the pad inorganic layer P151 of an embodiment may solve short-circuit defects of the pad electrode PD caused during the manufacturing process.

In some aspects, the pad inorganic layer P151 of an embodiment is located on the edge of the pad anode electrode PAE, thereby alleviating the step of a portion overlapping the edge of the pad bank structure P160 when the pad bank structure P160 is formed in the subsequent process.

The pad inorganic layer P151 of an embodiment may be formed in the same process as the pixel defining layer 151 located in the display area DA. In other words, the display device 10 may form the pad inorganic layer P151 by executing the process executed in the display area DA in the sub-area SBA without additional process. Accordingly, the pad structure PDS of an embodiment may also have ease of manufacturing.

The pad inorganic layer P151 of an embodiment may include the same material as the pixel defining layer 151 located in the display area DA. For example, the pad inorganic layer P151 may include aluminium oxide, titanium oxide, tantalum oxide, hafnium oxide, zinc oxide, silicon oxide, silicon nitride, or silicon oxynitride.

The pad bank layer P160 of an embodiment may include a first pad bank layer P161 and a second pad bank layer P163. The first pad bank layer P161 may be disposed on the pad inorganic layer P151 and the pad anode electrode PAE. The first pad bank layer P161 may be in direct contact with the pad anode electrode PAE exposed at a portion overlapping the third opening OP151. Accordingly, the first pad bank layer P161 may be electrically connected to the pad electrode PD through the pad anode electrode PAE.

The first pad bank layer P161 of an embodiment may include the same material as the first bank layer 161 located in the display area DA. The first pad bank layer P161 may include metal with high electrical conductivity and, for example, may include aluminium (Al).

The second pad bank layer P163 of an embodiment may be disposed on the first pad bank layer P161. The second pad bank layer P163 may be in direct contact with the first pad bank layer P161. For example, the second pad bank layer P163 may be electrically connected to the pad electrode PD through the pad anode electrode PAE and the first pad bank layer P161.

The second pad bank layer P163 of an embodiment may include the same material as the second bank layer 163. For example, the second pad bank layer P163 may form titanium (Ti).

The process of forming the pad bank structure P160 of an embodiment may be performed as a separate process rather than the same process as the process of forming the bank structure 160 located in the display area DA. Accordingly, the side surface of the second pad bank layer P163 of the pad bank structure P160 may be parallel to the side surface of the first pad bank layer P161. The manufacturing process will be described herein.

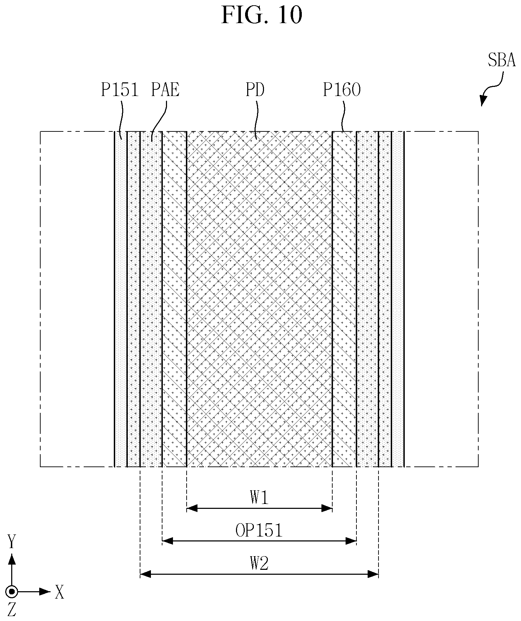

FIG. 10 is an enlarged schematic plan view of area A in FIG. 9.

Referring to FIG. 10, at a portion overlapping the sub-area SUB in a plan view, the pad electrode PD of an embodiment may include a uniform first width W1 in the first direction (X-axis direction) and extend in the second direction (Y-axis direction).

In a plan view, the pad anode electrode PAE of an embodiment may entirely cover the pad electrode PD. In other words, in a plan view, the pad anode electrode PAE of an embodiment may include a uniform second width W2 and entirely cover the pad electrode PD. In other words, in a plan view, the second width W2 of the pad anode electrode PAE may be greater than the first width W1 of the pad electrode PD.

In a plan view, the pad inorganic layer P151 of an embodiment may define the third opening OP151, and expose the pad anode electrode PAE at a portion overlapping the third opening OP151. In other words, in a plan view, the pad inorganic layer P151 of an embodiment may entirely cover the edges of the pad anode electrode PAE and expose the central portion of the pad anode electrode PAE.

In a plan view, the pad bank structure P160 of an embodiment may entirely cover the pad electrode PD, and in a plan view, the pad bank structure P160 may cover a portion of the pad anode electrode PAE and a portion of the pad inorganic layer P151.

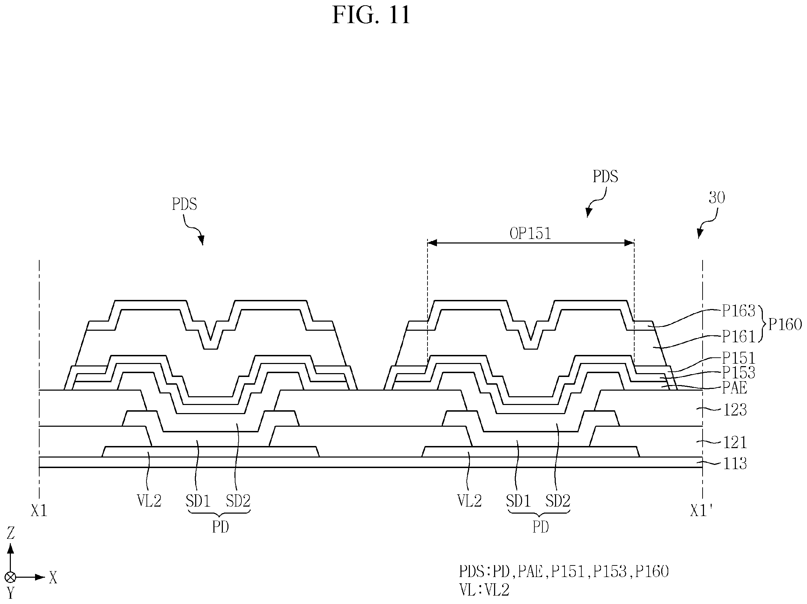

FIG. 11 is a schematic cross-sectional view taken along line X1-X1' in FIG. 4 according to another embodiment.

Referring to FIG. 11, the pad structure PDS included in a display device 30 of an embodiment is the same as the display device 10 in that the pad structure PDS includes the pad electrode PD, the pad anode electrode PAE, the pad inorganic layer P151, the pad residual pattern P153, and the pad bank structure P160, but has a difference in that the pad residual pattern P153 of the display device 30 entirely covers the pad anode electrode PAE. Hereinafter, any redundant description of the display device 10 and the display device 30 will not be repeated, and differences will be mainly described.

The pad residual pattern P153 included in the display device 30 of an embodiment may be located on the pad anode electrode PAE. The pad residual pattern P153 may entirely cover the upper surface of the pad anode electrode PAE, and be in entire contact with the top surface of the pad anode electrode PAE.

Since the display device 30 of an embodiment forms the pad residual pattern P153 to cover the entire surface of the pad anode electrode PAE, a process of etching a portion of the pad residual pattern P153 may not be included, and accordingly, the display device 30 may have ease of manufacturing.

The pad inorganic layer P151 included in the display device 30 of an embodiment may have a third opening OP151 and expose the pad residual pattern P153 at a portion overlapping the third opening OP151. The exposed pad residual pattern P153 may be in contact with the pad bank structure P160 at a portion overlapping the third opening OP151.

As described herein, the pad residual pattern P153 may include a transparent oxide electrode (TCO). Accordingly, the pad bank structure P160 of an embodiment may be electrically connected to the pad anode electrode PAE and the pad electrode PD by the pad residual pattern P153. Other redundant descriptions will be omitted.

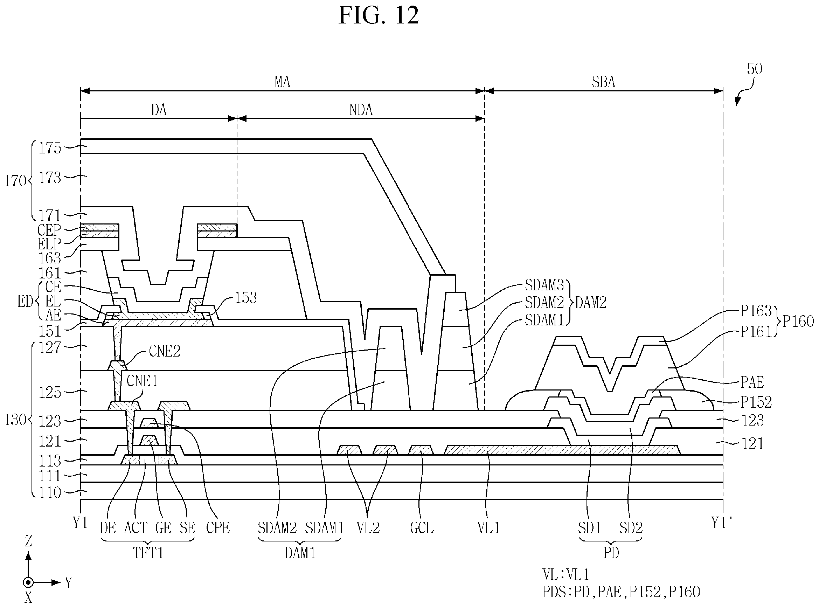

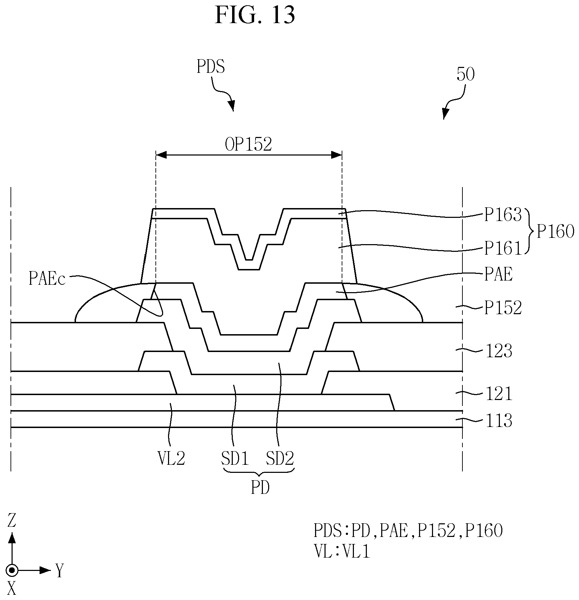

FIG. 12 is a schematic cross-sectional view taken along line Y1-Y1' in FIG. 4 according to another embodiment. FIG. 13 is an enlarged cross-sectional view of a pad structure PDS in FIG. 12.

Referring to FIGS. 12 and 13, the pad structure PDS included in a display device 50 of an embodiment is different from the display device 10 in that the pad structure PDS includes the pad electrode PD, the pad anode electrode PAE, the pad organic layer P152 and the pad bank structure P160. Hereinafter, the structure common in the display device 50 and the display device 10 will not repeated, and differences between the display device 50 and the display device 10 will be mainly described.

The pad anode electrode PAE included in the display device 50 of an embodiment may be located on the pad electrode PD. The pad anode electrode PAE may be located on the second pad electrode SD2 and be in contact with the second pad electrode SD2. The pad anode electrode PAE and the pad electrode PD may be electrically connected.

The pad organic layer P152 included in the display device 50 of an embodiment may be located on the second insulating layer 123. The pad organic layer P152 may define an opening OP152 and surround the opening OP152 to cover the edge of the second pad electrode SD2. In some aspects, the pad organic layer P152 may cover a side surface PAEc of the pad anode electrode PAE. Although the pad organic layer P152 is illustrated as being formed in an upwardly convex shape, embodiments of the present disclosure are not limited thereto. The pad organic layer P152 may be formed in various forms depending on the manufacturing process.

The pad organic layer P152 of an embodiment covers the edge of the second pad electrode SD2, thereby preventing etching byproducts from permeating into the pad electrode PD caused during the manufacturing process of the display device 50. Accordingly, the pad organic layer P152 of an embodiment may solve short-circuit defects of the pad electrode PD caused during the manufacturing process.

In some aspects, the pad organic layer P152 of an embodiment is located on the edge of the pad anode electrode PAE, thereby alleviating the step of a portion overlapping the edge of the pad bank structure P160 when the pad bank structure P160 is formed in the subsequent process.

The pad organic layer P152 of an embodiment may be formed in the same process as the first via layer 125 during the manufacturing process of the display device 50. In other words, the display device 50 may form the pad organic layer P152 by executing the process executed in the display area DA, in the sub-area SBA, without additional process. Accordingly, the pad structure PDS of an embodiment may have ease of manufacturing.

The pad organic layer P152 of an embodiment may include the same material as the first via layer 125 and the second via layer 127. For example, the pad organic layer P152 may include an organic insulating material.

The pad anode electrode PAE of an embodiment may be exposed at a portion overlapping the opening OP152. The exposed pad anode electrode PAE may be in contact with the pad bank structure P160, and the pad anode electrode PAE and the pad bank structure P160 may be electrically connected at the portion overlapping the opening OP152.

The pad bank structure P160 of an embodiment may be located on the pad anode electrode PAE and the pad organic layer P152. The pad bank structure P160 may be in contact with the pad anode electrode PAE and the pad organic layer P152. Other redundant descriptions will be omitted.

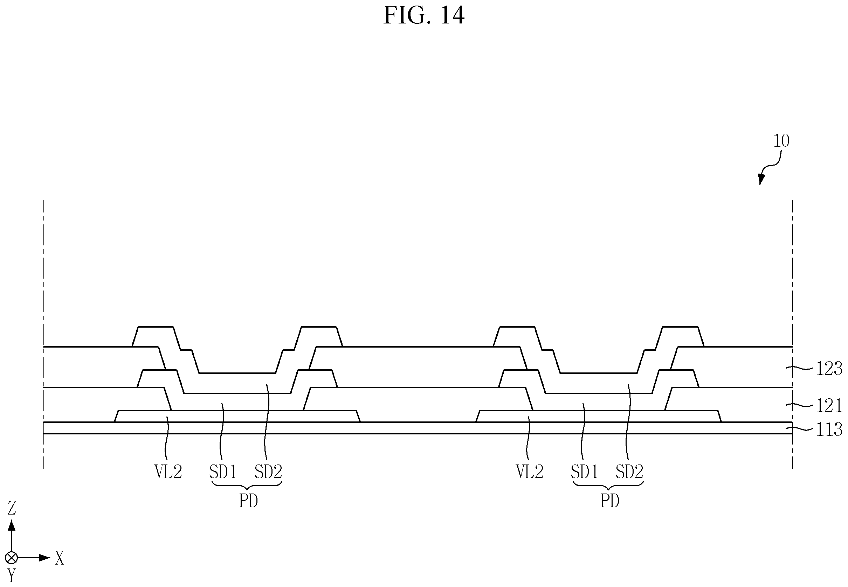

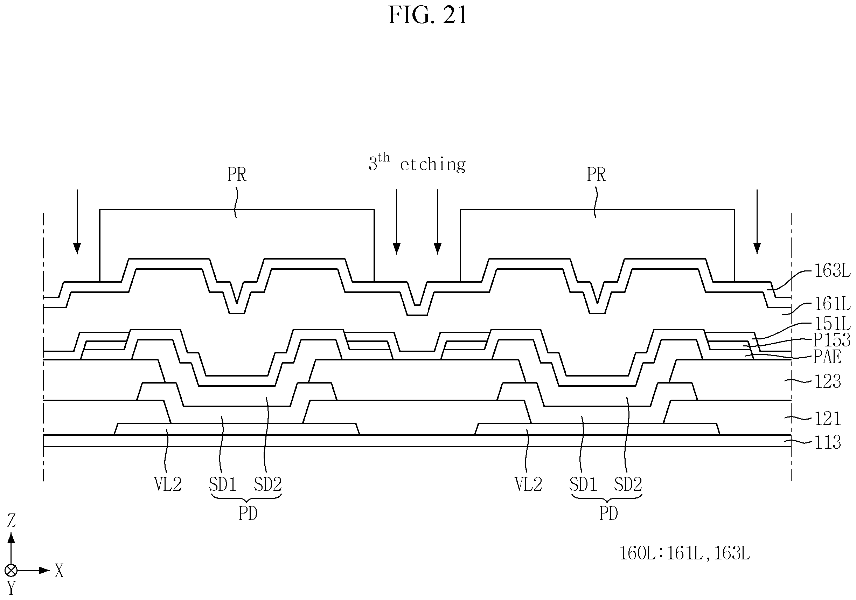

FIGS. 14 to 22 are cross-sectional views illustrating a method of fabricating a pad structure PDS of FIG. 9. Hereinafter, a method of manufacturing a pad structure PDS of a display device 10 will now be described with reference to other drawings. In the descriptions of the method and process herein, the operations may be performed in a different order than the order shown and/or described, or the operations may be performed in different orders or at different times. Certain operations may also be left out of the flowcharts, one or more operations may be repeated, or other operations may be added.

Referring to FIG. 14, the method may include forming a plurality of pad electrodes PD on each of the first insulating layer 121 and the second insulating layer 123. The plurality of pad electrodes PD may be spaced apart from each other in the first direction (X-axis direction). Each of the pad electrodes PD may include a first pad electrode SD1 and a second pad electrode SD2. Each of the pad electrodes PD may be formed to be in contact with the second power line VL2, and the pad electrode PD and the second power line VL2 may be electrically connected. Although the pad electrode PD and the second power line VL2 are illustrated as being in contact and described accordingly in the drawing, according to an embodiment, the pad electrode PD may be in contact with the entire plurality of lines included in the display device 10.

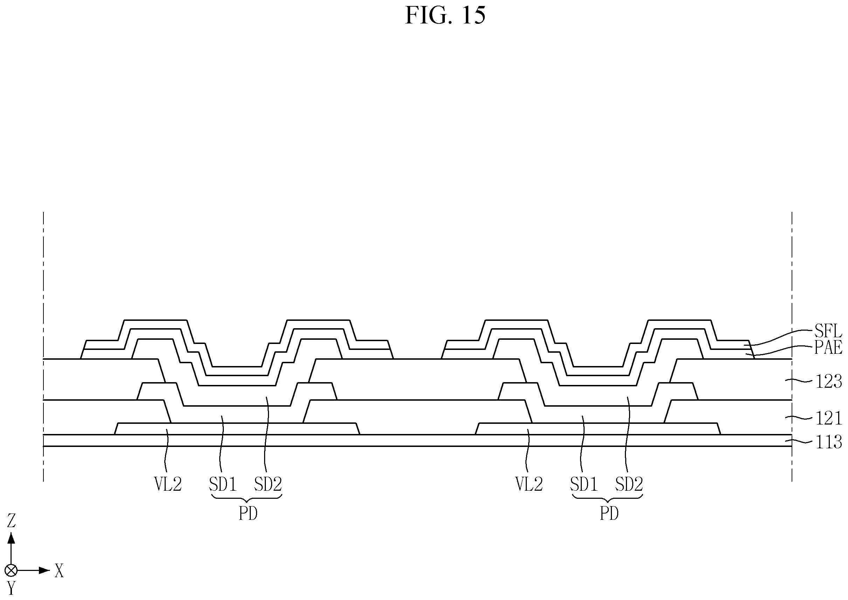

Referring to FIG. 15, the method may include forming the pad anode electrode PAE covering each of the pad electrode PD and forming a sacrificial layer SFL on the pad anode electrode PAE.

In the present process, the pad anode electrode PAE may entirely cover the pad electrode PD. As described herein, the pad anode electrode PAE may serve to protect the etching byproducts from permeating into the pad electrode PD during the manufacturing process. The method may include performing the process of forming the pad anode electrode PAE simultaneously with the process of forming the anode electrode AE illustrated in FIGS. 5 and 6.

In the present process, the sacrificial layer SFL may entirely cover the upper surface of the pad anode electrode PAE. The method may include performing the process of forming the sacrificial layer SFL simultaneously with the process of forming the residual pattern 153 illustrated in FIGS. 5 and 6. The sacrificial layer SFL may assist in preventing the pixel defining layer 151 and the anode electrode AE illustrated in FIGS. 5 and 6 from contacting each other, and protect the pad anode electrode PAE from a subsequent etching process.

The sacrificial layer SFL may include an oxide semiconductor. For example, the sacrificial layer SFL may include at least one of indium-gallium-zinc-oxide (IGZO), zinc-tin-oxide (ZTO), and indium-tin-oxide (IZO).

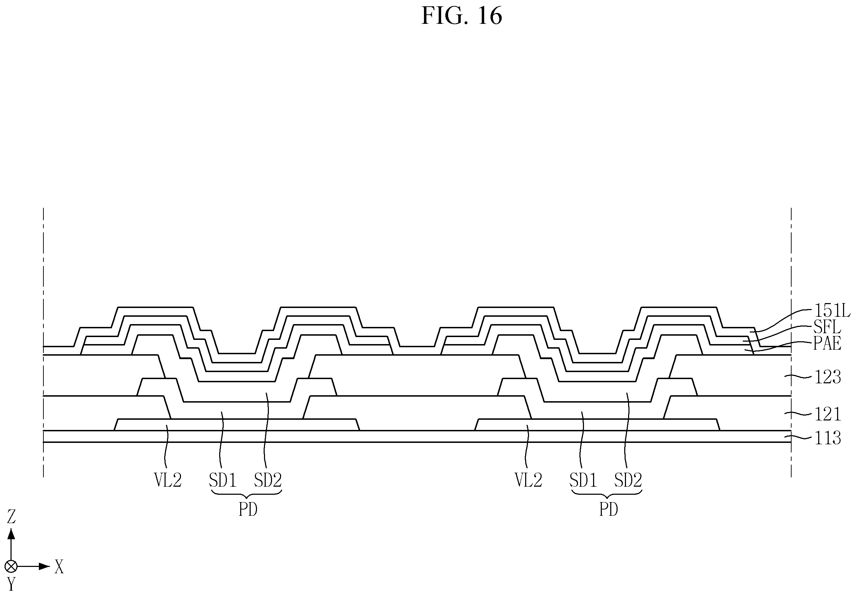

Subsequently, referring to FIG. 16, the method may include forming a pixel defining material layer 151L on the sacrificial layer SFL. The pixel defining material layer 151L may be in contact with the sacrificial layer SFL and entirely cover the sacrificial layer SFL. The method may include performing the process of forming the pixel defining material layer 151L simultaneously with the process of forming the pixel defining layer 151 illustrated in FIGS. 5 and 6. The pixel defining material layer 151L may protect the pad anode electrode PAE from a subsequent etching process.

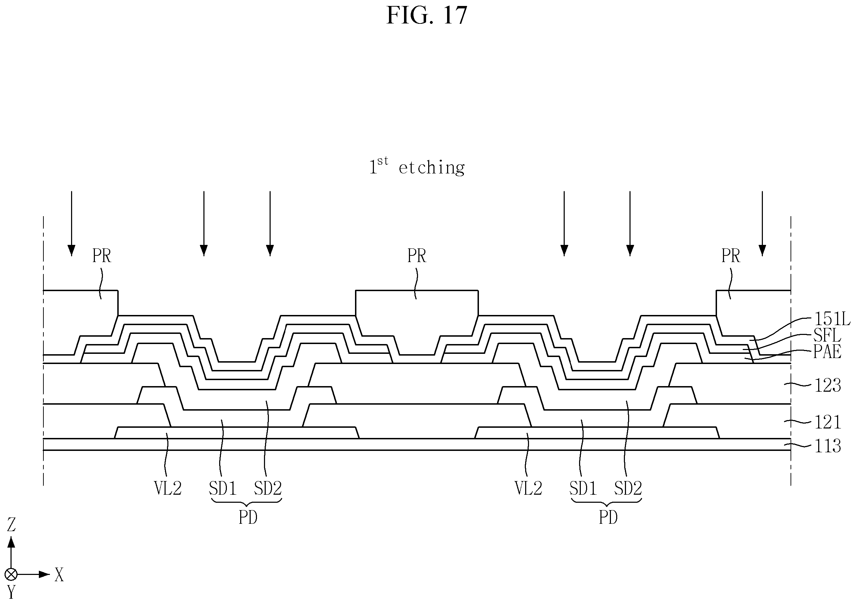

Next, referring to FIGS. 17 to 19, the method may include forming a photoresist PR on the pixel defining material layer 151L first while exposing a portion overlapping the pad electrode PD. Subsequently, the method may include performing a first etching (1^{st} etching) that etches a portion of the pixel defining material layer 151L using the photoresist PR as a mask. For example, as the first etching (1^{st} etching) is performed as a dry-etching process, the method may include etching a portion of the pixel defining material layer 151L.

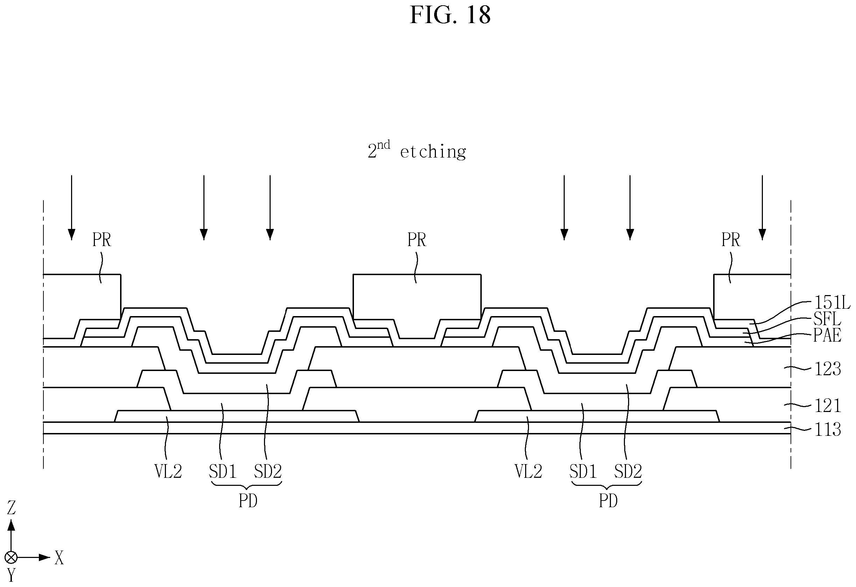

As illustrated in FIG. 18, the method may include removing a portion of the pixel defining material layer 151L located at a portion overlapping the pad electrode PD in the present process, and accordingly, the method may include forming the pixel defining material layer 151L in a shape covering the edge of the pad anode electrode PAE.

Subsequently, the method may include again forming a photoresist PR on the pixel defining material layer 151L while exposing the portion overlapping the pad electrode PD. Thereafter, the method may include performing a second etching (2^{nd} etching) that etches a portion of the sacrificial layer SFL using the photoresist PR as a mask. For example, as the second etching (2^{nd} etching) is performed as a wet-etching process, a portion of the sacrificial layer SFL may be etched.

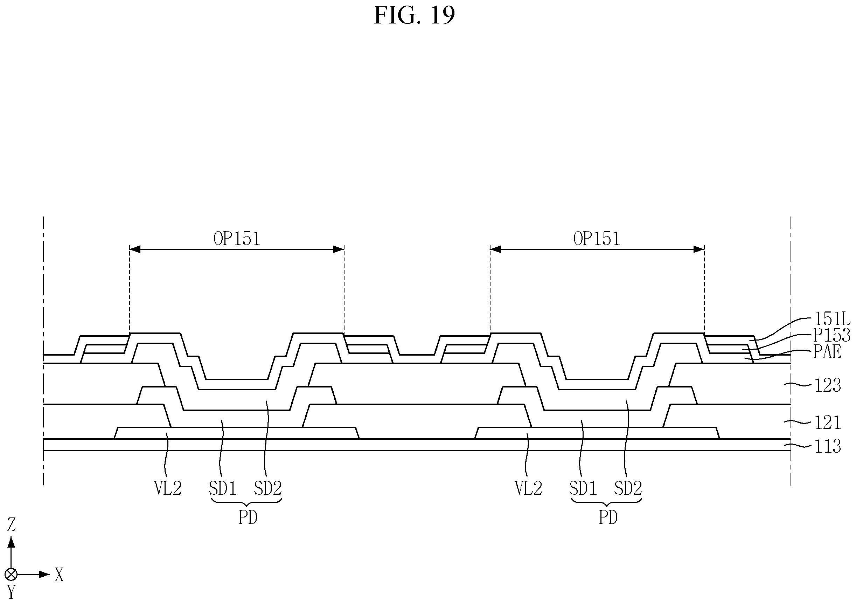

As illustrated in FIG. 19, the method may include removing a portion of the sacrificial layer SFL located at a portion overlapping the pad electrode PD in the present process, and accordingly, the sacrificial layer SFL may be formed in a shape covering the edge of the pad anode electrode PAE.

Through the present process, the method may include forming the sacrificial layer SFL in the form of the pad residual pattern P153 illustrated in FIG. 9. In other words, the method may include forming the pad residual pattern P153 such that the pad residual pattern P153 covers the entire pad anode electrode PAE during the manufacturing process, and the pad residual pattern P153 may remain after a portion of the pad anode electrode PAE has been removed by a subsequent etching process. As described herein, the pad residual pattern P153 may serve to protect the etching byproducts from permeating into the pad electrode PD during the manufacturing process.

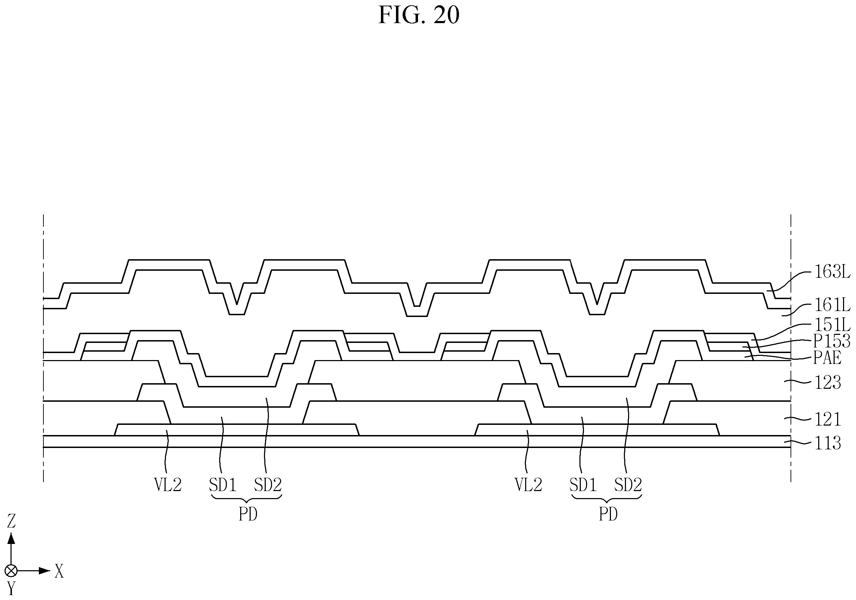

Subsequently, referring to FIGS. 20 to 22, the method may include depositing a first bank material layer 161L and a second bank material layer 163L on the pixel defining material layer 151L. The method may include directly disposing the first bank material layer 161L on the pixel defining material layer 151L, and the method may include directly disposing the second bank material layer 163L on the first bank material layer 161L. The method may include performing the process of forming the first bank material layer 161L and the second bank material layer 163L simultaneously with the process of forming the first bank layer 161 and the second bank layer 163 illustrated in FIGS. 5 and 6.

Next, the method may include forming a photoresist PR on the second bank material layer 163L at a portion overlapping the pad electrode PD, and performing a third etching process (3^{rd} etching) that etches a portion of a bank material layer 160L and the pixel defining material layer 151L using the photoresist PR as a mask.

The method may include performing the third etching process (3^{rd} etching) as a separate process from the process of etching the first bank layer 161 and the second bank layer 163 illustrated in FIGS. 5 and 6. For example, in the process of etching the first bank layer 161 and the second bank layer 163 located at a portion overlapping the display area DA, due to different etching rates of the first bank layer 161 and the second bank layer 163, the second bank layer 163 may be formed such that the second bank layer 163 protrudes more than the first bank layer 161. However, as the third etching process (3^{rd} etching) is performed as a dry-etching process, the third etching process (3^{rd} etching) may be performed such that the first bank material layer 161L and the second bank material layer 163L may be isotropically etched simultaneously.

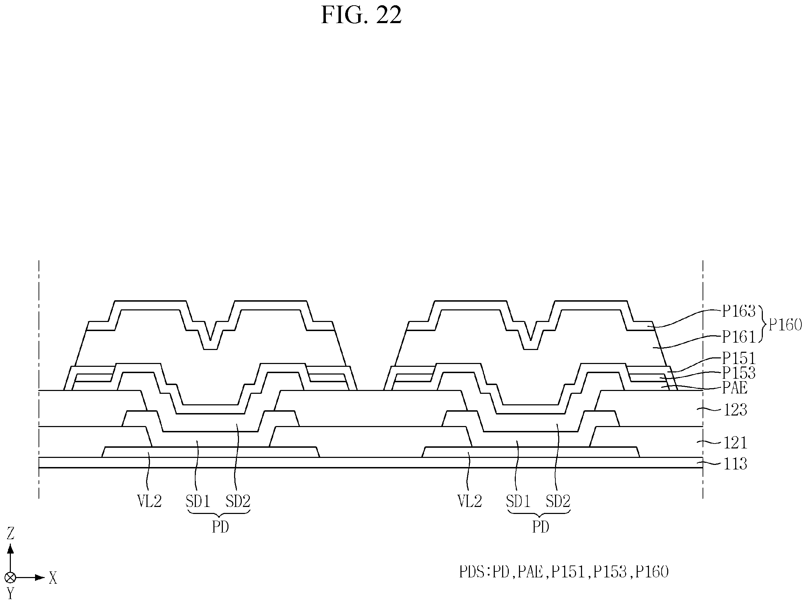

As illustrated in FIG. 22, the method may include removing a portion of the bank material layer 160L and the pixel defining material layer 151L located at a portion not overlapping the pad electrode PD in the present process, and accordingly, the method may include forming the bank material layer 160L in a form of the pad bank structure P160 illustrated in FIG. 9. In some aspects, the method may include forming the pixel defining material layer 151L in a form of the pad inorganic layer P151 illustrated in FIG. 9.

Accordingly, a pad structure PDS included in the display device 10 may be formed. As the pad structure PDS included in the display device 10 of an embodiment includes the pad anode electrode PAE entirely covering the pad electrode PD, short-circuit defects of the pad electrode PD due to inflow of etching byproducts caused during the manufacturing process may be solved.

In some aspects, as the pad structure PDS included in the display device 10 includes the pad residual pattern P153 and the pad inorganic layer P151 covering the edge of the pad anode electrode PAE, the step of the edge of the pad bank structure P160 may be alleviated (i.e., the step height may be reduced) and short-circuit defects of the pad electrode PD due to inflow of etching byproducts caused during the manufacturing process may be solved.

However, the effects of the disclosure are not restricted to the one set forth herein. The above and other effects of the disclosure will become more apparent to one of ordinary skill in the art to which the disclosure pertains by referencing the claims.

## Claims

1. A display device comprising:
a substrate comprising a main area and a sub-area disposed on one side of the main area;
an anode electrode located on the main area of the substrate;
a pixel defining layer located on the anode electrode, covering an edge of the anode electrode and defining a first opening;
a bank structure located on the pixel defining layer and defining a second opening, the bank structure comprising a first bank layer and a second bank layer having a tip protruding further toward the first opening than a side surface of the first bank layer; and
a pad structure located on the sub-area of the substrate and not overlapping the main area,
wherein the pad structure comprises:
a pad electrode;
a pad anode electrode located on the pad electrode and comprising a same material as the anode electrode; and
a pad bank structure located on the pad anode electrode and comprising a same material as the bank structure.

2. The display device of claim 1,
further comprising a pad inorganic layer located on the pad anode electrode and defining a third opening,
wherein the pad inorganic layer comprises a same material as the pixel defining layer.

3. The display device of claim 2,
wherein the pad inorganic layer surrounds the third opening and entirely covers an edge of the pad anode electrode.

4. The display device of claim 2 or claim 3,
wherein the pad anode electrode entirely covers the pad electrode and is entirely in contact with the pad electrode.

5. The display device of claim 4,
wherein the pad anode electrode is in contact with the pad bank structure at a portion overlapping the third opening, and
the pad bank structure and the pad electrode are electrically connected by the pad
anode electrode, optionally wherein a first width of the pad electrode in a direction parallel to the substrate is smaller than a second width of the pad anode electrode in the direction parallel to the substrate.

6. The display device of any one of claims 2 to 5,
further comprising a residual pattern located between the anode electrode and the pixel defining layer in a direction perpendicular to the substrate,
wherein the residual pattern comprises a transparent oxide electrode (TCO), optionally
further comprising:
a light emitting layer located on the anode electrode and in contact with the side surface of the first bank layer; and
a cathode electrode located on the light emitting layer and in contact with the side surface of the first bank layer,
wherein the light emitting layer is in contact with the residual pattern, and
the cathode electrode is electrically connected to the first bank layer.

7. The display device of claim 6,
further comprising a pad residual pattern located between the pad anode electrode and the pad inorganic layer in a direction perpendicular to the substrate,
wherein the pad residual pattern comprises a same material as the residual pattern.

8. The display device of claim 7, wherein:
(i) the pad residual pattern is completely surrounded by the pad anode electrode and the pad inorganic layer; and/or
(ii) wherein the pad residual pattern completely covers the pad anode electrode, and the pad residual pattern is in contact with the pad bank structure at a portion overlapping the third opening.

9. The display device of claim 2,
wherein the pad anode electrode completely covers the pad electrode in a plan view,
the pad inorganic layer exposes the pad anode electrode at a portion overlapping the third opening in the plan view, and
the pad inorganic layer entirely covers the edge of the pad anode electrode in the plan view.

10. The display device of any one of claims 1 to 9,
wherein the pad bank structure comprises a first pad bank layer comprising a same material as the first bank layer and a second pad bank layer comprising a same material as the second bank layer.

11. The display device of claim 10,
wherein:
(i) the first bank layer and the first pad bank layer comprise aluminium (Al), and the second bank layer and the second pad bank layer comprise titanium (Ti); and/or
(ii) the display device further comprises a dam structure between the bank structure and the pad bank structure, wherein the bank structure and the pad bank structure are spaced apart from each other.

12. The display device of any one of claims 1 to 11,
wherein the first opening is completely surrounded by the second opening in a plan view.

13. The display device of claim 1,
further comprising a pad organic layer located on the pad electrode, defining a third opening, and comprising an organic insulating material,
wherein the pad organic layer covers an edge of the pad electrode, and
the pad organic layer is in contact with a side surface of the pad anode electrode.

14. A method of fabricating a display device, the method comprising:
forming a pad electrode on a substrate, forming a pad anode electrode on the pad electrode, and forming a sacrificial layer on the pad anode electrode;
after forming a pad inorganic layer on the sacrificial layer, removing a portion of the pad inorganic layer and a portion of the sacrificial layer through an etching process, wherein removing the portion of the pad inorganic layer and the portion of the sacrificial layer exposes the pad anode electrode; and
after forming a pad bank structure on the pad anode electrode and the pad inorganic layer, removing a portion of the pad bank structure.

15. The method of claim 14,
wherein based on removing the portion of the pad inorganic layer, a remaining portion of the pad inorganic layer entirely covers an edge of the pad anode electrode, optionally wherein the pad anode electrode is in contact with the pad electrode and the pad bank structure, and the pad electrode and the pad bank structure are electrically connected by the pad anode electrode.
